# EUROPEAN PATENT APPLICATION

(11) **EP 1 666 971 A1**
(43) Date of publication of application: **07.06.2006**
(21) Application number: 04746417.7
(22) Date of filing: 18.06.2004
(51) Int. Cl.: G03F 7/039, G03F 7/26, H01L 21/027

(54) **POSITIVE RESIST COMPOSITION AND RESIST LAMINATE FOR LOW-ACCELERATION ELECTRON BEAM AND METHOD OF PATTERN FORMATION**

(30) Priority: 25.09.2003 JP 2003334029; 06.10.2003 JP 2003347136
(71) Applicant: TOKYO OHKA KOGYO CO., LTD., Kawasaki-shi, Kanagawa 211-0012 (JP)
(72) Inventor: ANDO, Tomoyuki, Tokyo Ohka Kogyo Co., Ltd., Kawasaki-shi, Kanagawa 211-0012 (JP); HOJO, Takuma, Tokyo Ohka Kogyo Co., Ltd., Kawasaki-shi, Kanagawa 211-0012 (JP)
(74) Representative: Portal, Gérard
(86) International application number: PCT/JP2004/008948
(87) International publication number: WO 2005/031464

(57) **Abstract**

A positive resist composition and resist laminate for a low-acceleration electron beam, which exhibit excellent resolution and dry etching resistance, reduced thickness loss, and can be used favorably in a method of forming a resist pattern that includes a step of conducting exposure using a low-acceleration electron beam. This positive resist composition for a low-acceleration electron beam includes a resin component (A), which contains acid dissociable, dissolution inhibiting groups and exhibits increased alkali solubility under the action of acid, and an acid generator component (B) that generates acid on exposure, wherein the residual film ratio following alkali developing in the unexposed portions of the resist film formed from the positive resist composition for a low-acceleration electron beam is 80% or higher. The resist laminate includes a lower organic film layer that can be dry etched, an interlayer, and an upper resist film layer laminated sequentially on top of a substrate, wherein the upper resist film layer is formed from the above positive resist composition for a low-acceleration electron beam.

## Description

### TECHNICAL FIELD

The present invention relates to a positive resist composition for a low-acceleration electron beam that can be used favorably in an exposure step that uses a low-acceleration electron beam, a resist laminate that can be used favorably in a method of forming a resist pattern that includes such an exposure step, and a method of pattern formation.

Priority is claimed on Japanese Patent Application No. 2003-334029, filed September 25, 2003, and Japanese Patent Application No. 2003-347136, filed October 6, 2003, the contents of which are incorporated herein by reference.

### BACKGROUND ART

Generally, in semiconductor production, a resist laminate that includes a resist film formed on top of a substrate such as a silicon wafer is subjected to selective exposure, thereby forming a resist pattern within the resist film, and dry etching is then conducted using this resist pattern as a mask, thereby forming a pattern on the substrate.

One example of a known method of resist pattern formation is the three-layer resist method (for example, see patent reference 1). In this method, a base material containing a resin for film formation is first applied to the top of a substrate, this base material is heated to effect film formation, thus providing an organic film, a silica-based resist film (an interlayer) is provided on top of the organic film, and a resist film (an upper layer) is then provided on top of the interlayer. Subsequently, a resist pattern is formed in the upper layer using normal lithography techniques, the pattern is transferred to the interlayer using the resist pattern as a mask, the patterned interlayer is then used as a mask for conducting etching of the organic film, and pattern formation is then performed on the substrate. By using this method, a resist pattern with high resolution and a high aspect ratio can be formed.

In recent years, advances in lithography techniques have lead to ongoing, rapid miniaturization of resist patterns. Recently, levels of resolution capable of forming contact hole patterns of no more than 90 nm, and even of 70 nm or smaller, are being demanded.

However, even with lithography techniques that use ArF excimer lasers, which currently offer the best combination of suitability to mass production and the ability to form fine patterns, it is thought that resolution of the type of ultra fine contact hole patterns described above is at the limits of the technology.

On the other hand, lithography that uses electron beam patterning has long been proposed as a microprocessing technique capable of realizing high levels of resolution. However because this technique involves direct patterning, the throughput for each wafer is poor, meaning that it is not widely used as a mass production technique.

However, in recent years, mass production techniques using electron beams have begun to attract attention, and much research continues to be conducted into improving the drawbacks associated with electron beam patterning. The results of this research can be broadly classified into EPL (Electron Projection Lithography), which describes lithography techniques that use a high-acceleration electron beam stepper, and LEEPL (Low Energy Electron beam Projection Lithography), which describes a method of conducting exposure using a low-acceleration electron beam.

Positive resist compositions that have been proposed as ideal resist materials for use within methods that include an exposure step using an electron beam are typically chemically amplified positive resist compositions containing a polyhydroxystyrene-based resin in which a portion of the hydroxyl groups have been protected with acid dissociable, dissolution inhibiting groups as the base resin, and an acid generator. Examples of the most commonly used acid dissociable, dissolution inhibiting groups within the base resin include so-called acetal groups, such as chain-like ether groups typified by 1-ethoxyethyl groups, and cyclic ether groups typified by tetrahydropyranyl groups, as well as tertiary alkyl groups typified by tert-butyl groups, and tertiary alkoxycarbonyl groups typified by tert-butoxycarbonyl groups (for example, see patent references 2 and 3).

### (Patent Reference 1)

Japanese Unexamined Patent Application, First Publication No. 2001-51422

### (Patent Reference 2)

Japanese Unexamined Patent Application, First Publication No. Hei 8-262721

### (Patent Reference 3)

Japanese Unexamined Patent Application, First Publication No. 2002-341538

In the recent electron beam lithography techniques described above, the electron beam permeability of the resist layer is the most important factor. The electron beam permeability of the resist layer is influenced more by physical factors such as the film thickness of the resist layer than by the properties of the resist material. Furthermore, as the accelerating voltage during electron beam irradiation is lowered, the permeability also decreases. As a result, in those cases where a comparatively low accelerating voltage such as that employed in the aforementioned LEEPL technique is used, for example, a low-acceleration electron beam with an accelerating voltage of approximately 2 kV, a thin-film resist process is used to ensure adequate permeability of the resist layer by the electron beam.

However, conventional resist materials exhibit insufficient dry etching resistance for use within thin-film resist processes, and tend to suffer thickness loss during dry etching.

### DISCLOSURE OF INVENTION

The present invention takes the above problems associated with the conventional technology into consideration, with an object of providing a positive resist composition that exhibits excellent resolution and dry etching resistance, reduced thickness loss, and can be used favorably in a method of forming a resist pattern that includes a step of conducting exposure using a low-acceleration electron beam.

Furthermore, another object of the present invention is to provide a resist laminate and a method of pattern formation that can be used favorably for lithography that uses a low-acceleration electron beam.

As a result of intensive investigation aimed at achieving the above objects, the inventors of the present invention discovered that a correlation existed between the dry etching resistance and thickness loss of the resist film, and the solubility of the resist in an alkali developing solution, and that by using a positive resist composition in which the residual film ratio following alkali developing is at least 80%, the objects described above could be achieved. Furthermore, they also discovered that a positive resist composition that used a resin containing specific structural units as the base resin was able to achieve the above objects.

The present invention is based upon these findings, and a first aspect of the present invention is a positive resist composition for a low-acceleration electron beam that includes a resin component (A), which contains acid dissociable, dissolution inhibiting groups and exhibits increased alkali solubility under the action of acid, and an acid generator component (B) that generates acid on exposure, wherein
the residual film ratio following alkali developing in the unexposed portions of the resist film formed from the positive resist composition for a low-acceleration electron beam is 80% or higher.

Furthermore, a second aspect of the present invention is a positive resist composition for a low-acceleration electron beam that includes a resin component (A'), which contains alkali-soluble structural units (a1) and structural units (a2) that contain an acid dissociable, dissolution inhibiting group, and exhibits increased alkali solubility under the action of acid, and an acid generator component (B) that generates acid on exposure, wherein at least one of the structural units (a1) and (a2) within the resin component (A') contains a polycyclic group.

In this description, the term "structural unit" refers to a monomer unit that contributes to the formation of a polymer. Furthermore, the term "exposure" includes both electron beam patterning and irradiation through a mask.

A third aspect of the present invention is a resist laminate containing a lower organic film layer that can be dry etched, an interlayer, and an upper resist film layer laminated sequentially on top of a substrate, wherein
the upper resist film layer is formed from a positive resist composition for a low-acceleration electron beam that includes a resin component (A), which contains acid dissociable, dissolution inhibiting groups and exhibits increased alkali solubility under the action of acid, and an acid generator component (B) that generates acid on exposure, and the residual film ratio for the upper resist film layer is 80% or higher.

Furthermore, a fourth aspect of the present invention is a resist laminate containing a lower organic film layer that can be dry etched, an interlayer, and an upper resist film layer laminated sequentially on top of a substrate, wherein
the upper resist film layer is formed from a positive resist composition for a low-acceleration electron beam that includes a resin component (A'), which contains alkali-soluble structural units (a1) and structural units (a2) that contain an acid dissociable, dissolution inhibiting group, and exhibits increased alkali solubility under the action of acid, and an acid generator component (B) that generates acid on exposure, and at least one of the structural units (a1) and (a2) within the resin component (A') contains a polycyclic group.

Furthermore, a fifth aspect of the present invention is a method of pattern formation that includes sequentially conducting a laminate formation step of forming a resist laminate, a step of conducting exposure of the upper resist film layer of the resist laminate using a low-acceleration electron beam, and then conducting alkali developing to form a resist pattern in the upper resist film layer, a step of conducting oxide etching using the resist pattern as a mask pattern, thereby transferring the pattern to the interlayer, and a step of conducting dry etching of the lower organic film layer using the resist pattern and the pattern within the interlayer as a mask pattern, thereby forming a lower layer pattern within the lower organic film layer.

According to the present invention, a positive resist composition can be realized that exhibits excellent resolution and dry etching resistance, has reduced thickness loss, and can be used favorably in a method of forming a resist pattern that includes a step of conducting exposure using a low-acceleration electron beam.

Furthermore, according to the present invention, a resist pattern with a favorable cross-sectional shape, and a resist pattern with minimal developing defects can be formed.

### BEST MODE FOR CARRYING OUT THE INVENTION

As follows is a more detailed description of the present invention.

A positive resist composition for a low-acceleration electron beam according to the present invention includes a resin component (A) (hereafter also referred to as the component (A)), which contains acid dissociable, dissolution inhibiting groups and exhibits increased alkali solubility under the action of acid, and an acid generator component (B) (hereafter also referred to as the component (B)) that generates acid on exposure.

Regarding the component (A), the action of acid generated from the component (B) as a result of exposure causes the acid dissociable, dissolution inhibiting groups to dissociate, causing the entire component (A) to change from an alkali-insoluble state to an alkali-soluble state.

As a result, when a resist is exposed through a mask pattern during the formation of a resist pattern, or alternatively, is exposed and then subjected to post exposure baking (PEB), the exposed portions of the resist shift to an alkali-soluble state, whereas the unexposed portions remain insoluble in alkali, meaning that alkali developing can then be used to form a positive resist pattern.

A positive resist composition for a low-acceleration electron beam according to the present invention is used within a resist pattern formation method that includes the steps of applying the positive resist composition to a substrate and conducting a prebake to form a resist film, conducting selective exposure of the resist film using a low-acceleration electron beam, performing post exposure baking, and then conducting alkali developing to form a resist pattern. A low-acceleration electron beam is the type of electron beam typically used in an aforementioned LEEPL process.

### «Positive Resist Composition of the First Aspect»

A positive resist composition for a low-acceleration electron beam according to the first aspect of the present invention exhibits a residual film ratio following alkali developing in the unexposed portions of the resist film of 80% or higher. By ensuring this residual film ratio is at least 80%, the dry etching resistance of the resist film formed using the positive resist composition for a low-acceleration electron beam can be improved, the level of thickness loss during dry etching can be reduced, and a high resolution resist pattern can be obtained. Accordingly, the composition can be used favorably within a method of forming a resist pattern that includes a step of conducting exposure using a low-acceleration electron beam.

In this description, the term "residual film ratio" is determined by comparing the film thickness of a resist film formed by applying the positive resist composition for a low-acceleration electron beam to the surface of a substrate and then conducting a prebake, with the film thickness of the same resist film following developing for 60 seconds at 23°C in a 2.38% by weight aqueous solution of tetramethylammonium hydroxide, using a formula: [(film thickness of the resist film following developing) / (film thickness of the resist film prior to developing)] x 100 (%). The film thickness of the resist film prior to alkali developing used in the measurement of the residual film ratio is preferably within the film thickness range typically used in thin-film processes, for example, within a range from 50 to 100 nm.

In other words, the present invention arose from the discovery that a positive resist composition that exhibits a variation in resist film thickness upon alkali developing that is less than a certain value, that is, a positive resist composition with a high level of resistance to the alkali developing solution, provides excellent dry etching resistance, and is ideal for use within a low-acceleration electron beam exposure process. The reason that positive resist compositions with a high level of resistance to alkali developing solutions also exhibit excellent dry etching resistance is not entirely clear, but is thought to be due to the existence of bulky groups within the resin backbone.

The residual film ratio is even more preferably 90% or higher, and even more preferably 95% or higher, and is preferably as close as possible to 100%.

Adjustment of the residual film ratio can be achieved using known methods such as altering the nature and blend quantities of the component (A) and the component (B), or altering the nature and blend quantities of optional components combined with the components (A) and (B).

For example, the alkali solubility of the unexposed portions can be increased, thereby increasing the residual film ratio, by a variety of methods including using bulky groups such as adamantyl groups for the acid dissociable, dissolution inhibiting groups within the component (A), increasing the protection ratio provided by the acid dissociable, dissolution inhibiting groups, increasing the weight average molecular weight, adding dissolution inhibitors, or introducing bulky groups such as adamantyl groups within resin side chains, even in regions separate from the acid dissociable, dissolution inhibiting groups.

In a positive resist composition for a low-acceleration electron beam according to the first aspect of the present invention, any resin typically used within positive resist compositions can be used as the component (A), provided the residual film ratio for the resulting resist film is at least 80%. In a preferred configuration, a polymer used as the component (A') in a positive resist composition according to the second aspect of the present invention, such as a polymer (A'1) or copolymer (A'2) described below, can be favorably employed. Furthermore, the nature and blend quantities of the component (B) and any other components that are added as required are the same as those described below for a positive resist composition according to the second aspect of the present invention.

### «Positive Resist Composition of the Second Aspect»

### [Component (A')]

In a positive resist composition for a low-acceleration electron beam according to the second aspect of the present invention, the resin component (A') (hereafter also referred to as the component (A')) contains alkali-soluble structural units (a1) and structural units (a2) that contain an acid dissociable, dissolution inhibiting group, exhibits increased alkali solubility under the action of acid, and is a polymer (hereafter also referred to as the polymer (A')) in which at least one of the structural units (a1) and (a2) contains a polycyclic group. By using a polymer (A') that contains either a structural unit (a1) or structural unit (a2) containing an aforementioned polycyclic group, the dry etching resistance of the resist film obtained using the positive resist composition for a low-acceleration electron beam can be improved, the level of thickness loss during dry etching can be reduced, and a high resolution resist pattern can be obtained. Accordingly, the composition can be used favorably within a method of forming a resist pattern that includes a step of conducting exposure using a low-acceleration electron beam.

By using the polymer (A'), the dry etching resistance of a positive resist composition of the present invention improves, and the level of thickness loss during dry etching decreases. The reasons for these observations are thought to include an improvement in the dry etching resistance as a result of the polycyclic groups, and an increase in the hydrophobicity of the resist film surface caused by the polycyclic groups, which makes the resist film surface more resistant to dissolution, thereby reducing thickness loss.

In this description, the term "alkali-soluble structural units" refers to structural units that include a polar group such as a hydroxyl group or carboxyl group within the structural unit, wherein the monomer derived from the structural unit is soluble in alkali such as alkali developing solutions.

Examples of the structural unit (a1) include structural units derived from hydroxystyrene or α-methylhydroxystyrene, that is, structural units (a11) represented by a general formula (I) shown below: 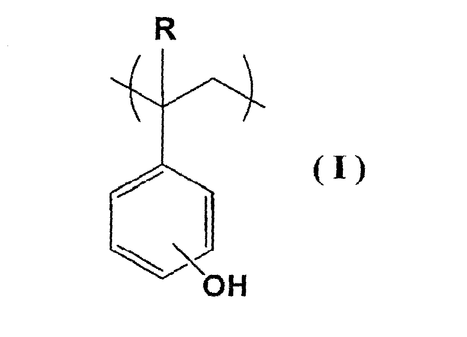 [wherein, R represents a hydrogen atom or a methyl group], structural units derived from (meth)acrylic acids containing an aliphatic polycyclic group with an alcoholic hydroxyl group such as the units (a12) described below, and structural units derived from (meth)acrylic acid. Of these, the structural units (a11) and (a12) are preferred as they offer a high level of dry etching resistance, are readily available, and are low cost.

The term "(meth)acrylic acid" refers to methacrylic acid and/or acrylic acid.

In the formula (I), R represents a hydrogen atom or a methyl group, and is preferably a hydrogen atom. If R is a hydrogen atom, the protection ratio of the hydroxyl groups can be increased, enabling the contrast to be improved. Furthermore, the solubility rate following developing can also be increased. The bonding position of the hydroxyl group may be the o-position, the m-position, or the p-position, although the viewpoints of availability and cost, the p-position is preferred.

Examples of the structural unit (a2) include structural units derived from the structural units (a11), (a12) and (meth)acrylic acid listed above in relation to the structural unit (a1), wherein the hydrogen atom of the phenolic hydroxyl group, alcoholic hydroxyl group, or carboxyl group has been substituted with a conventional acid dissociable, dissolution inhibiting group, or an acid dissociable, dissolution inhibiting group that is the subject of a separate application made by the applicants of the present invention.

As the conventional acid dissociable, dissolution inhibiting group, any of the acid dissociable, dissolution inhibiting groups proposed for use within chemically amplified KrF positive resist compositions or ArF positive resist compositions can be used, and suitable examples include chain-like or cyclic tertiary alkyl groups such as a tert-butyl group, tert-amyl group, 1-methylcyclopentyl group, 1-ethylcyclopentyl group, 1-methylcyclohexyl group, or 1-ethylcyclohexyl group; cyclic ether groups such as a tetrahydropyranyl group or tetrahydrofuranyl group; and 1-lower alkoxyalkyl groups in which the 1-position is substituted with a straight-chain, branched, or cyclic alkoxy group of 1 to 8 carbon atoms. The acid dissociable, dissolution inhibiting groups that are the subject of a separate application made by the applicants of the present invention are represented by a general formula (II) in the polymer (A'1) described below.

The polycyclic groups within the aforementioned polymer (A') that includes at least one of the structural units (a1) and (a2) containing a polycyclic group may be either aliphatic polycyclic groups or aromatic polycyclic groups, and are preferably either aliphatic polycyclic groups of 10 to 16 carbon atoms or aromatic polycyclic hydrocarbon groups of 10 to 16 carbon atoms. Of these, aliphatic polycyclic groups yield favorable levels of line edge roughness and rectangularity of the cross-sectional shape for the resulting resist pattern, and are consequently preferred.

Examples of aliphatic polycyclic groups of 10 to 16 carbon atoms include groups in which one or two hydrogen atoms have been removed from a bicycloalkane, tricycloalkane or tetracycloalkane or the like.

Specific examples include groups in which one or two hydrogen atoms have been removed from a polycycloalkane such as adamantane, norbornane, isobornane, tricyclodecane or tetracyclododecane. These types of polycyclic groups can be appropriately selected from the multitude of groups proposed for use with conventional ArF resists. Of these groups, adamantyl groups, norbornyl groups, and tetracyclododecanyl groups are preferred industrially, and adamantyl groups are particularly desirable.

By including aliphatic polycyclic groups, a high level of resolution is obtained and the cross-sectional shape of the resist pattern becomes a favorable rectangular shape.

Examples of aromatic polycyclic groups of 10 to 16 carbon atoms include groups in which one or two hydrogen atoms have been removed from naphthalene, anthracene, phenanthrene, or pyrene or the like. Specific examples include 1-naphthyl groups, 2-naphthyl groups, 1-anthracenyl groups, 2-anthracenyl groups, 1-phenanthryl groups, 2-phenanthryl groups, 3-phenanthryl groups, and 1-pyrenyl groups, and of these, 2-naphthyl groups are preferred industrially.

By including aromatic polycyclic groups within the polymer (A'), the sensitivity of the positive resist composition of the present invention becomes more favorable, and the throughput is high, meaning that the productivity can be improved.

The description stating that at least one of the structural units (a1) and (a2) contains a polycyclic group means an aforementioned polycyclic group is chemically bonded via an organic chemical bond to the structural unit. Furthermore, the polycyclic group may also include functional groups that promote alkali solubility as a hydroxyl group or carboxyl group, and lower alkyl groups such as a methyl group, ethyl group, or propyl group, and may also be incorporated within a portion of the acid dissociable, dissolution inhibiting group. Specific examples include the structural units (a12) and (a21) described below.

The proportion of the structural units (a1) within the polymer (A') is preferably within a range from 50 to 95 mol%, and even more preferably from 60 to 85 mol%, of all the structural units that constitute the polymer (A'). This ensures that a suitable level of alkali solubility is obtained.

The proportion of the structural units (a2) within the polymer (A') is preferably within a range from 5 to 45 mol%, and even more preferably from 15 to 40 mol%, of all the structural units that constitute the polymer (A). This ensures that the alkali insolubility of the unexposed portions of the resist film can be adequately maintained during formation of the resist pattern.

The weight average molecular weight (the polystyrene equivalent value determined using gel permeation chromatography (GPC), this also applies to all subsequent molecular weight values) of the polymer (A') is preferably within a range from 2,000 to 30,000, and even more preferably from 4,000 to 20,000 prior to protection with the acid dissociable, dissolution inhibiting groups, and is preferably within a range from 3,500 to 33,000, and even more preferably from 5,500 to 23,000 following protection. By ensuring that the weight average molecular weight is no more than 30,000, satisfactory solubility of the polymer within the resist solvent can be obtained, whereas ensuring the weight average molecular weight is at least 2,000 improves the dry etching resistance of the resulting resist pattern, thereby improving thickness loss. Furthermore, larger weight average molecular weight values tend to result in higher residual film ratios.

In the present invention, a positive resist composition of the present invention that includes the polymer (A') preferably satisfies the condition of the first aspect, namely, that the residual film ratio is at least 80%.

The residual film ratio can be increased, for example, by increasing the proportion of the aforementioned polycyclic groups within the polymer (A'), or by increasing the weight average molecular weight of the polymer (A').

Examples of preferred forms of the component (A') in the present invention include polymers containing aforementioned structural units (a1), in which the hydrogen atoms of a portion of the hydroxyl groups within the structural units (a1) are protected with acid dissociable, dissolution inhibiting groups, and wherein either the structural units (a1) include a polycyclic group, or the acid dissociable, dissolution inhibiting groups include a polycyclic group, or both the structural units (a1) and the acid dissociable, dissolution inhibiting groups include a polycyclic group. Examples of this type of polymer include a polymer (A'1) and a copolymer (A'2) described below. By using either the polymer (A'1) or the copolymer (A'2) described below as the component (A'), the level of dry etching resistance required for this thin-film process can be ensured, the level of thickness loss during dry etching can be reduced, a resist pattern of high resolution can be obtained, and the occurrence of pattern defects within the resist pattern following developing (developing defects) can be suppressed. It is thought that the reason for these observations is that by reducing the thickness of the film, the quantity of the resin component within the resist film is reduced.

### <Polymer (A'1)>

The polymer (A'1) is a polymer that contains the structural units (a11) described above, and structural units (a21), wherein the hydrogen atoms of a portion of the hydroxyl groups of the structural units (a11) are protected with acid dissociable, dissolution inhibiting groups represented by a general formula (II) shown below. 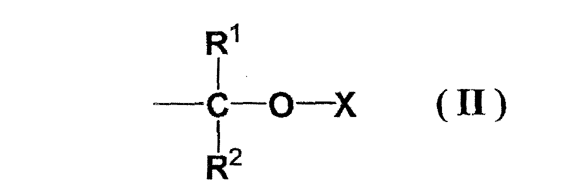 [wherein, R¹ represents an alkyl group of 1 to 5 carbon atoms, R² represents an alkyl group of 1 to 5 carbon atoms or a hydrogen atom, and X represents an aliphatic polycyclic group or an aromatic polycyclic hydrocarbon group]

In the formula (II), R¹ is a straight-chain or branched alkyl group of 1 to 5 carbon atoms, and suitable examples include a methyl group, ethyl group, propyl group, isopropyl group, n-butyl group, isobutyl group, tert-butyl group, pentyl group, isopentyl group, or neopentyl group. From an industrial viewpoint, a methyl group or ethyl group is preferred.

R² is an alkyl group of 1 to 5 carbon atoms or a hydrogen atom. Examples of suitable alkyl groups of 1 to 5 carbon atoms include the same substituent groups described above for R¹. Of these, from an industrial viewpoint, R² is preferably a hydrogen atom.

X is an aliphatic polycyclic group or an aromatic polycyclic group, and this ensures that a high residual film ratio can be achieved. Furthermore, an improvement in etching resistance and a reduction in thickness loss can also be achieved.

Examples of X include the same polycyclic groups as those described above. Of these, aliphatic polycyclic groups yield favorable levels of line edge roughness and rectangularity of the cross-sectional shape for the resulting resist pattern, and are consequently preferred.

Specific examples of preferred acid dissociable, dissolution inhibiting groups for the structural units (a21) include the groups shown below.

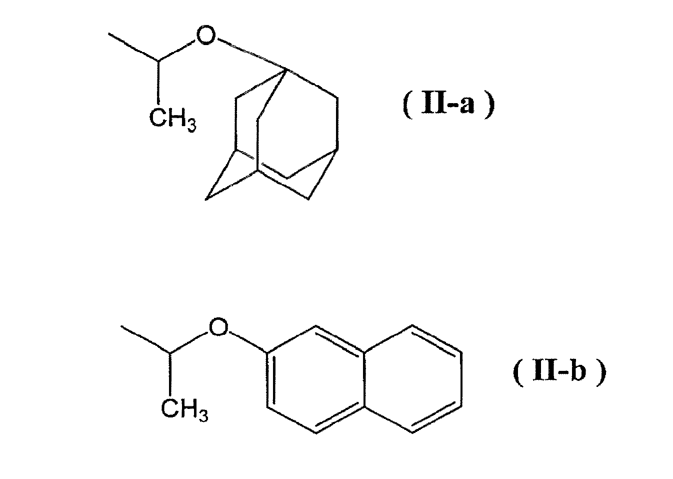

### [Structural Unit (a3)]

The polymer (A'1) may also be a copolymer which, in addition to the aforementioned structural units (a11) and (a21), also includes structural units (a3) represented by a general formula (III) shown below.

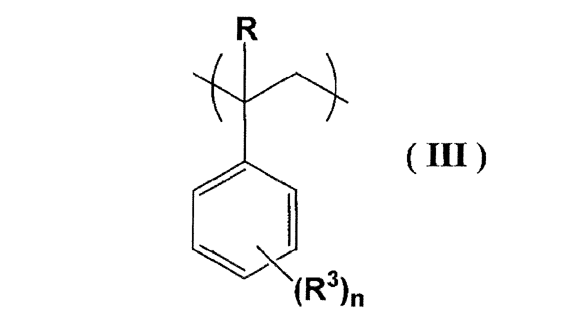

### [wherein, R represents a hydrogen atom or a methyl group, R³ represents an alkyl group of 1 to 5 carbon atoms, and n represents either 0 or an integer of 1 to 3]

In the formula (III), R³ is a straight-chain or branched alkyl group of 1 to 5 carbon atoms, and suitable examples include a methyl group, ethyl group, propyl group, isopropyl group, n-butyl group, isobutyl group, tert-butyl group, pentyl group, isopentyl group, or neopentyl group. From an industrial viewpoint, a ethyl group or ethyl group is preferred.

The aforementioned n is either 0, or an integer from 1 to 3. Of these possibilities, n is preferably either 0 or 1, and from an industrial viewpoint, is most preferably 0.

In those cases where n is from 1 to 3, the bonding position of the substituent group R³ may be the o-position, the m-position, or the p-position, and if n is 2 or 3, then any combination of substituent positions is suitable.

In the present invention, the structural units (a3) are not essential, although including them enables the alkali solubility to be controlled, thereby controlling the residual film ratio, by adjusting the quantity of the structural units (a3). Furthermore, other benefits are also obtained, including a reduction in line edge roughness, and an ability to produce favorable isolated line patterns. If the structural units (a3) are used, then the quantity of such units is preferably within a range from 0.5 to 25 mol%, and even more preferably from 3 to 20 mol%, of the combined total of all the structural units that constitute the polymer (A'1). If the quantity of the structural units (a3) is greater than this range, then the alkali solubility reduces, line edge roughness tends to increase, and favorable isolated lines become more difficult to achieve.

In a positive resist composition of the present invention, as the polymer (A'1), either a single polymer can be used alone, or a mixture of two or more such polymers may be used.

In those cases where a mixture of two or more polymers is used as the polymer (A'1), any two or more polymers selected from a group consisting of polymers containing the aforementioned structural units (a11) and the aforementioned structural units (a21), and copolymers containing the structural units (a11), the structural units (a21), and the structural units (a3) can be combined. In other words, polymers with different weight average molecular weights or polymers with different relative proportions of each of the structural units can be mixed together as desired. In a preferred configuration, a mixture of a polymer containing the structural units (a11) and the structural units (a21), and a copolymer containing the structural units (a11), the structural units (a21), and the structural units (a3) is used. By using this type of mixture as the polymer (A'1), the shape of the formed resist pattern exhibits favorable rectangularity, and a superior isolated line pattern can be obtained.

The weight average molecular weight (the polystyrene equivalent value, this also applies to all subsequent molecular weight values) of the polymer (A'1) prior to protection with the acid dissociable, dissolution inhibiting groups, is preferably within a range from 2,000 to 30,000, and even more preferably from 5,000 to 20,000. By ensuring the weight average molecular weight is no more than 30,000, the solubility in the resist solvent can be improved, whereas ensuring the value is at least 2,000 enables an improvement in the dry etching resistance, thereby improving the level of thickness loss for the resulting resist pattern. Furthermore, a favorable resist pattern shape can also be obtained.

Furthermore, a larger weight average molecular weight results in a higher residual film ratio.

Furthermore, in terms of the dispersity (the weight average molecular weight divided by the number average molecular weight, this also applies below) of the polymer (A'1) prior to protection with the acid dissociable, dissolution inhibiting groups, a monodisperse polymer with a small dispersity yields superior resolution and is consequently preferred. Specifically, the dispersity is preferably no more than 2.0, and even more preferably 1.5 or less.

In the present invention, the proportion of the structural units (a11), relative to the combined total of all the structural units that constitute the polymer (A'1), is typically within a range from 50 to 95 mol%, and preferably from 60 to 85 mol%, and the proportion of the structural units (a21) is typically within a range from 5 to 45 mol%, and preferably from 15 to 40 mol%.

If the polymer contains none of the structural units (a3), then the proportion of the structural units (a21), relative to the combined total of all the structural units, is preferably within a range from 5 to 35 mol%, and even more preferably from 20 to 30 mol%.

If the polymer contains the structural units (a3), then the proportion of the structural units (a21), relative to the combined total of all the structural units, is preferably within a range from 5 to 35 mol%, and even more preferably from 10 to 20 mol%.

By ensuring that the proportion is at least as large as the lower limit of the above range, favorable contrast can be achieved, whereas ensuring that the proportion is no greater than the upper limit of the above range enables a developing defect suppression effect to be achieved.

The polymer (A'1) can be produced, for example, by polymerizing a monomer corresponding with the structural unit (a11), in which the hydrogen atom of the hydroxyl group is not protected, and then using a known method to protect a portion of the hydroxyl groups of the structural units (a11) with acid dissociable, dissolution inhibiting groups.

Furthermore, the polymer (A'1) can also be produced by preparing a monomer corresponding with the structural unit (a21), in which the hydrogen atom of the hydroxyl group has already been protected with an acid dissociable, dissolution inhibiting group, subsequently polymerizing this monomer using normal methods, and then using hydrolysis to change the hydrogen atoms of a portion of the hydroxyl groups that have been protected with acid dissociable, dissolution inhibiting groups back to hydrogen atoms.

### <Copolymer (A'2)>

The copolymer (A'2) contains the aforementioned structural units (a11), and structural units (a12) derived from a (meth)acrylate ester containing an aliphatic polycyclic group with an alcoholic hydroxyl group as essential structural units, wherein the hydrogen atoms of a portion of the hydroxyl groups of the structural units (a11) and the alcoholic hydroxyl groups of the structural units (a12) are protected with acid dissociable, dissolution inhibiting groups.

In addition to the first structural units (a11) and the second structural units (a12), this copolymer (A'2) may also include the same structural units (a3) as those described in relation to the aforementioned polymer (A'1).

### [Structural Unit (a12)]

The structural units (a12) are structural units derived from a (meth)acrylate ester containing an aliphatic polycyclic group with an alcoholic hydroxyl group.

These structural units (a12) exhibit a lower solubility in alkali developing solutions than the structural units (a11), meaning that the copolymer (A'2) has a lower solubility in alkali developing solutions, than conventional resins in which the hydrogen atoms of a portion of the hydroxyl groups of a polyhydroxystyrene have been protected with acid dissociable, dissolution inhibiting groups, once the acid dissociable, dissolution inhibiting groups have been dissociated. Accordingly, a satisfactory degree of insolubility in the alkali developing solution can be achieved with a protection ratio that is lower than that of conventional polyhydroxystyrene-based resins, and as a result, a higher residual film ratio can be achieved. Furthermore, an improvement in etching resistance and a reduction in thickness loss can also be achieved. Moreover, developing defects caused by the acid dissociable, dissolution inhibiting groups can be suppressed, and a high level of resolution can be achieved.

In other words, in the copolymer (A'2), by replacing some of the structural units (a11) with the structural units (a12), which introduce alcoholic hydroxyl groups with poorer alkali solubility than phenolic hydroxyl groups into a portion of the base resin side chains, the solubility of the copolymer in alkali developing solutions can be reduced. Furthermore, because the copolymer contains aliphatic polycyclic groups with alcoholic hydroxyl groups, it exhibits excellent levels of resolution and dry etching resistance.

Provided the structural units (a12) within the copolymer (A'2) display this action, then there are no particular restrictions on the structure, and any structural unit derived from a (meth)acrylate ester containing an aliphatic polycyclic group with an alcoholic hydroxyl group can be used.

Examples of the polycyclic group that constitutes the aliphatic polycyclic group containing an alcoholic hydroxyl group include groups in which one hydrogen atom has been removed from a bicycloalkane, tricycloalkane or tetracycloalkane or the like. Specific examples include groups in which one hydrogen atom has been removed from a polycycloalkane such as adamantane, norbornane, isobornane, tricyclodecane or tetracyclododecane. These types of polycyclic groups can be appropriately selected from the multitude of groups proposed for use with ArF resists and the like. Of these groups, adamantyl groups, norbornyl groups, and tetracyclododecanyl groups are preferred industrially.

As the structural unit (a12), structural units derived from (meth)acrylate esters containing an adamantyl group with at least one alcoholic hydroxyl group, as represented by a general formula (IV) shown below, can be particularly favorably employed.

Of the structural units (a12) represented by the general formula (IV) shown below, structural units represented by a general formula (IVa) are the most desirable. 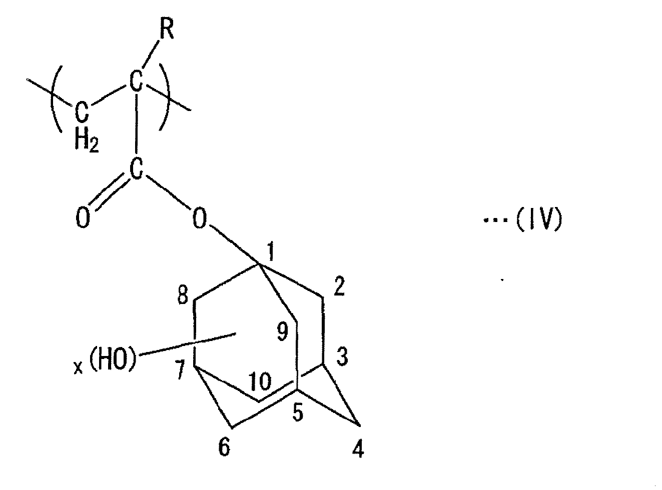 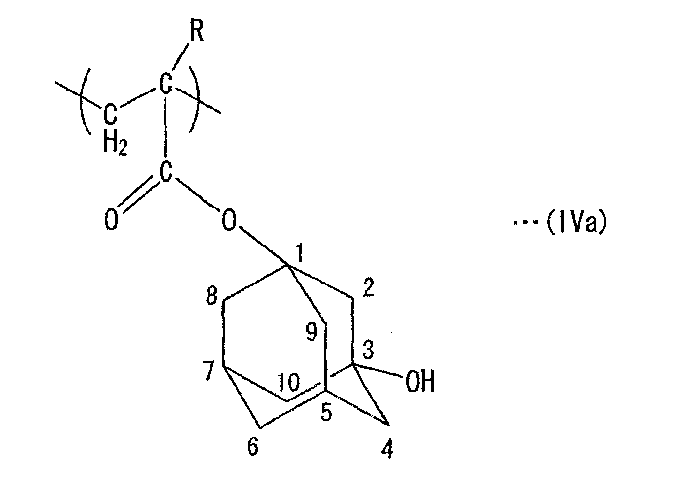 (wherein, R represents a hydrogen atom or a methyl group, and x represents an integer from 1 to 3)

Furthermore, of the possible structural units (a12), structural units derived from acrylate esters exhibit a higher solubility in alkali developing solutions, once the acid dissociable, dissolution inhibiting groups have been dissociated, than structural units derived from methacrylate esters, that the protection ratio provided by the acid dissociable, dissolution inhibiting groups can be increased, enabling the contrast to be improved. Accordingly, the use of structural units derived from an acrylate ester containing an alcoholic hydroxyl group as the structural unit (a12) enables developing defects to be suppressed while the resolution is improved, and is consequently preferred. At least 80 mol% of the structural units (a12) are preferably structural units derived from an acrylate ester containing an alcoholic hydroxyl group, and a proportion of 100% is even more desirable.

### [Acid Dissociable, Dissolution Inhibiting Groups of the Copolymer (A'2)]

In the copolymer (A'2), the hydrogen atoms of a portion of the hydroxyl groups of the structural units (a11) and the alcoholic hydroxyl groups of the structural units (a12) must be protected with acid dissociable, dissolution inhibiting groups.

Examples of these acid dissociable, dissolution inhibiting groups include the same groups as those described in relation to the aforementioned structural unit (a2). Of these, 1-lower alkyl alkoxyalkyl groups in which the 1-position is substituted with a straight-chain, branched, or cyclic alkoxy group of 1 to 8 carbon atoms, that is, 1-lower alkyl alkoxyalkyl groups represented by a general formula (V) shown below, are preferred. Specific examples of these groups include straight-chain and branched alkoxyalkyl groups such as 1-ethoxyethyl groups and 1-isopropoxyethyl groups, and cyclic alkoxyalkyl groups such as 1-cyclohexyloxyethyl groups, and of these, 1-ethoxyethyl groups are particularly desirable as they provide excellent resolution performance. 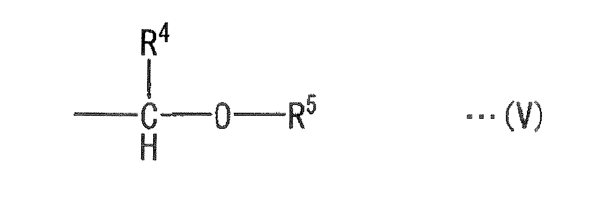 (wherein R⁴ represents an alkyl group of 1 to 4 carbon atoms, and R⁵ represents either a straight-chain or branched alkyl group of 1 to 8 carbon atoms, or a cycloalkyl group of 5 to 7 carbon atoms)

In the present invention, the protection ratio for the hydroxyl groups (the proportion of hydroxyl group hydrogen atoms substituted with acid dissociable, dissolution inhibiting groups) within the copolymer (A'2) is preferably set so that at least 10 mol% but no more than 35 mol% of the combined total of hydroxyl groups within the structural units (a11) and alcoholic hydroxyl groups within the structural units (a12) are protected, with ratios of at least 20 mol% but no more than 30 mol% being particularly desirable.

By ensuring that the hydroxyl group protection ratio is no greater than the upper limit of the above range, the occurrence of pattern defects within the resist pattern following developing (developing defects) can be effectively prevented. On the other hand, ensuring that the hydroxyl group protection ratio is at least as large as the lower limit of the above range improves the etching resistance and reduces thickness loss. Furthermore, deterioration in the resolution performance can also be suppressed. Furthermore, a higher hydroxyl group protection ratio results in a higher residual film ratio.

In the copolymer (A'2), the hydroxyl groups protected by the acid dissociable, dissolution inhibiting groups may be either the hydroxyl groups of the structural units (a11) or the alcoholic hydroxyl groups of the structural units (a12), and although there are no particular restrictions, copolymers in which either only the hydroxyl groups of the structural units (a11) (the hydroxystyrene phenolic hydroxyl groups) are protected, or copolymers in which both the hydroxyl groups of the structural units (a11) and the alcoholic hydroxyl groups of the structural units (a12) are protected by the acid dissociable, dissolution inhibiting groups, are preferred. Furthermore, although dependent on the actual acid dissociable, dissolution inhibiting groups used, the case in which both the hydroxyl groups of the structural units (a11) and the alcoholic hydroxyl groups of the structural units (a12) are protected by the acid dissociable, dissolution inhibiting groups is usually the most preferred.

In the copolymer (A'2), the molar ratio between the structural units (a11) and the structural units (a12), prior to protection with the acid dissociable, dissolution inhibiting groups is preferably within a range from 95:5 to 75:25, and even more preferably from 82:18 to 78:22.

If the proportion of the structural units (a12) exceeds the above range, then the solubility of the copolymer within the developing solution is inadequate, whereas if the proportion is too small, the effect achieved by using the structural units (a12) is not adequately manifested.

Furthermore, in the copolymer (A'2), the combination of the structural units (a11) and the structural units (a12) within the copolymer, prior to protection with the acid dissociable, dissolution inhibiting groups, preferably accounts for at least 90 mol% of the combined total of all the structural units that constitute the copolymer (A'2). If this proportion is less than 90 mol%, the resolution tends to deteriorate. The proportion of the copolymer accounted for by the combination of the structural units (a11) and the structural units (a12) is even more preferably 95 mol% or greater, and is most preferably 100 mol%.

In the present invention, the structural units (a3) are not essential, although including them provides certain benefits such as improving the depth of focus, and further improving the dry etching resistance.

If the structural units (a3) are included, then the proportion of the structural units (a3) within the copolymer (A'2) is preferably within a range from 0.5 to 10 mol%, and even more preferably from 2 to 5 mol%, of the combined total of all the structural units that constitute the copolymer (A'2). If the quantity of the structural units (a3) is greater than this range, then the solubility of the copolymer (A'2) in the developing solution tends to deteriorate.

In the copolymer (A'2), the weight average molecular of the copolymer, prior to protection of the hydrogen atoms of a portion of the hydroxyl groups with acid dissociable, dissolution inhibiting groups, is preferably at least 2,000 but no more than 8,500, and is even more preferably at least 4,500 but no more than 8,500. Provided the weight average molecular weight is no more than 8,500, the dry etching resistance of the resulting resist pattern can be improved, and the level of thickness loss also improves. Furthermore, the generation of microbridges can also be prevented. Furthermore, provided the weight average molecular weight is at least 2,000, the heat resistance is favorable. Furthermore, the weight average molecular weight of the copolymer following protection with the acid dissociable, dissolution inhibiting groups, based on the aforementioned protection ratio provided by the acid dissociable, dissolution inhibiting groups, is preferably at least 8,600 but no more than 20,000, and is even more preferably at least 9,000 but no more than 15,000.

In this description, the term "microbridge" describes a type of developing defect, where in a line and space pattern, for example, portions of adjacent resist patterns near the surface of the pattern are linked together via a bridge formed from the resist. Microbridges are increasingly likely for higher weight average molecular weight values, and for higher temperatures within post exposure baking (PEB).

Furthermore, prior to protection of the hydrogen atoms of a portion of the hydroxyl groups with acid dissociable, dissolution inhibiting groups, the copolymer (A'2) is preferably a monodisperse system with a low dispersity (Mw/Mn ratio), as this provides superior resolution. Specifically, the dispersity is typically no more than 2.0, and preferably 1.7 or less.

The copolymer (A'2) can be produced, for example, by copolymerizing a monomer corresponding with the structural unit (a11) in which the hydroxyl group is not protected, and a monomer corresponding with the structural unit (a12) in which the hydroxyl group is not protected, and then using a known method to protect the hydrogen atoms of a portion of the hydroxyl groups of the structural units (a11) and/or the structural units (a12) with acid dissociable, dissolution inhibiting groups.

Furthermore, the copolymer (A'2) can also be produced by preparing a monomer corresponding with a structural unit in which the hydroxyl group of the structural unit (a11) has already been protected with an acid dissociable, dissolution inhibiting group, copolymerizing this monomer with a monomer corresponding with the structural unit (a12) using normal methods, and then using hydrolysis to change a portion of the hydroxyl groups that have been protected with acid dissociable, dissolution inhibiting groups back to hydroxyl groups, and where necessary, using normal methods to protect a portion of the hydroxyl groups of the structural units (a12) with acid dissociable, dissolution inhibiting groups.

In a positive resist composition of the present invention, the component (A') may be either one of the aforementioned polymer (A'1) and the aforementioned copolymer (A'2), or may also be a mixture of the two.

In a positive resist composition for a low-acceleration electron beam according to the present invention, the quantity of the component (A) or component (A') may be adjusted in accordance with the thickness of the resist film that is to be formed, but when reported as a solid fraction concentration, is typically within a range from 5 to 25% by weight, and even more preferably from 7 to 20% by weight.

### [Component (B)]

As the component (B), a compound appropriately selected from known materials used as acid generators in conventional chemically amplified photoresists can be used.

Of the possible acid generators, onium salts containing a fluorinated alkylsulfonate ion as the anion, and oxime sulfonate compounds are preferred.

Specific examples of suitable onium salts include diphenyliodonium trifluoromethanesulfonate, (4-methoxyphenyl)phenyliodonium trifluoromethanesulfonate, bis(p-tert-butylphenyl)iodonium trifluoromethanesulfonate, triphenylsulfonium trifluoromethanesulfonate, (4-methoxyphenyl)diphenylsulfonium trifluoromethanesulfonate, (4-methylphenyl)diphenylsulfonium nonafluorobutanesulfonate, (p-tert-butylphenyl)diphenylsulfonium trifluoromethanesulfonate, diphenyliodonium nonafluorobutanesulfonate, bis(p-tert-butylphenyl)iodonium nonafluorobutanesulfonate, triphenylsulfonium nonafluorobutanesulfonate, (4-trifluoromethylphenyl)diphenylsulfonium trifluoromethanesulfonate, (4-trifluoromethylphenyl)diphenylsulfonium nonafluorobutanesulfonate, and tri(p-tert-butylphenyl)sulfonium trifluoromethanesulfonate.

Specific examples of suitable oxime sulfonate-based compounds include α-(methylsulfonyloxyimino)-phenylacetonitrile, α-(methylsulfonyloxyimino)-p-methoxyphenylacetonitrile, α-(trifluoromethylsulfonyloxyimino)-phenylacetonitrile, α-(trifluoromethylsulfonyloxyimino)-p-methoxyphenylacetonitrile, α-(ethylsulfonyloxyimino)-p-methoxyphenylacetonitrile, α-(propylsulfonyloxyimino)-p-methylphenylacetonitrile, and α-(methylsulfonyloxyimino)-p-bromophenylacetonitrile. Of these, α-(methylsulfonyloxyimino)-p-methoxyphenylacetonitrile is preferred.

As the component (B), either a single acid generator may be used alone, or a combination of two or more different acid generators may be used.

The quantity used of the component (B) is typically within a range from 0.5 to 30 parts by weight, and preferably from 1 to 10 parts by weight, per 100 parts by weight of the component (A) or the component (A'). If the quantity is less than 0.5 parts by weight, then pattern formation may not progress satisfactorily, whereas if the quantity exceeds 30 parts by weight, it becomes difficult to achieve a uniform solution, and there is also a danger of a deterioration in the storage stability of the composition.

### [Component (C)]

A positive resist composition according to the present invention can be produced by dissolving the materials in an organic solvent (C) (hereafter referred to as the component (C)).

The component (C) may be any solvent capable of dissolving each of the components used to generate a uniform solution, and either one, or two or more solvents selected from known materials used as the solvents for conventional chemically amplified resists can be used.

Suitable examples include γ-butyrolactone; ketones such as acetone, methyl ethyl ketone, cyclohexanone, methyl isoamyl ketone and 2-heptanone; polyhydric alcohols and derivatives thereof such as ethylene glycol, ethylene glycol monoacetate, diethylene glycol, diethylene glycol monoacetate, propylene glycol, propylene glycol monoacetate, dipropylene glycol, or the monomethyl ether, monoethyl ether, monopropyl ether, monobutyl ether or monophenyl ether of dipropylene glycol monoacetate; cyclic ethers such as dioxane; and esters such as methyl lactate, ethyl lactate, methyl acetate, ethyl acetate, butyl acetate, methyl pyruvate, ethyl pyruvate, methyl methoxypropionate, and ethyl ethoxypropionate. These organic solvents can be used alone, or as a mixed solvent of two or more different solvents.

There are no particular restrictions on the quantity of solvent used, which is selected to yield a concentration that is able to be applied to a substrate or the like. For example, the solid fraction that constitutes the positive resist composition of the present invention (the fraction that remains as a solid when the solvent (C) is removed) is typically within a range from 2 to 20% by weight, and preferably from 3 to 15% by weight.

### [Component (D)]

In a positive photoresist composition of the present invention, in order to improve the resist pattern shape and the post exposure stability of the latent image formed by the pattern-wise exposure of the resist layer, a nitrogen-containing organic compound can also be added as an optional component (D).

A multitude of these nitrogen-containing organic compounds have already been proposed, and any of these known compounds can be used, although an amine, and in particular a secondary aliphatic amine or tertiary aliphatic amine is preferred. Here, an aliphatic amine refers to an alkyl or alkylalcohol amine.

Specific examples of the component (D) include alkyl amines such as trimethylamine, diethylamine, triethylamine, di-n-propylamine, tri-n-propylamine, tripentylamine, tri-n-heptylamine, tri-n-octylamine, di-n-heptylamine, di-n-octylamine, and tri-n-dodecylamine; and alkylalcohol amines such as diethanolamine, triethanolamine, diisopropanolamine, triisopropanolamine, di-n-octanolamine, and tri-n-octanolamine. Of these, secondary or tertiary aliphatic amines containing an alkyl group of 7 to 15 carbon atoms are preferred. By ensuring that the component contains an alkyl group of 7 to 15 carbon atoms, the dispersion of the aliphatic amine through the resist pattern is suppressed, enabling a more uniform distribution. In the present invention, alkyl amines such as tri-n-octylamine are particularly preferred.

These compounds may be used alone, or in combinations of two or more different compounds.

This component is typically used in a quantity within a range from 0.01 to 5.0 parts by weight per 100 parts by weight of the component (A).

### [Component (E)]

Furthermore, in order to prevent any deterioration in sensitivity caused by the addition of the aforementioned component (D), and improve the resist pattern shape and the post exposure stability of the latent image formed by the pattern-wise exposure of the resist layer, an organic carboxylic acid, or a phosphorus oxo acid or derivative thereof can also be added as another optional component (E). The component (D) and the component (E) can be used in combination, or either one can also be used alone.

Examples of suitable organic carboxylic acids include malonic acid, citric acid, malic acid, succinic acid, benzoic acid, and salicylic acid.

Examples of suitable phosphorus oxo acids or derivatives thereof include phosphoric acid or derivatives thereof such as esters, including phosphoric acid, di-n-butyl phosphate and diphenyl phosphate; phosphonic acid or derivatives thereof such as esters, including phosphonic acid, dimethyl phosphonate, di-n-butyl phosphonate, phenylphosphonic acid, diphenyl phosphonate, and dibenzyl phosphonate; and phosphinic acid or derivatives thereof such as esters, including phosphinic acid and phenylphosphinic acid, and of these, phosphonic acid is particularly preferred.

The component (E) is typically used in a quantity within a range from 0.01 to 5.0 parts by weight per 100 parts by weight of the component (A).

### [Other Optional Components]

Other miscible additives can also be added to a positive resist composition of the present invention according to need, and examples include additive resins for improving the properties of the resist film, surfactants for improving the ease of application, dissolution inhibitors, plasticizers, stabilizers, colorants, and halation prevention agents.

### [Method of Forming a Resist Pattern]

A method of forming a resist pattern that uses a positive resist composition for a low-acceleration electron beam according to the present invention can be conducted, for example, in the manner described below.

Namely, a positive resist composition described above is first applied to the surface of a substrate such as a silicon wafer using a spinner or the like, and a prebake is then conducted under temperature conditions of 80 to 150°C for 40 to 120 seconds, and preferably for 60 to 90 seconds, thus forming a resist film.

In the present invention, the film thickness of this resist film can be reduced to a value within a range from 50 to 150 nm, and preferably from 50 nm to approximately 100 nm. The former range is for an accelerating voltage of 5 kV, and the latter for the case of an accelerating voltage of 2 kV.

Subsequently, this resist film may be patterned by direct irradiation with an electron beam without using a mask, but is preferably selectively exposed through a desired mask pattern using a low-acceleration electron beam exposure apparatus such as "LEEPL" (a product name, manufactured by Leepl Corporation, accelerating voltage: 2 kV). Conducting the exposure through a mask pattern provides certain advantages, including an improvement in the throughput, and the ability to form resist patterns with small gaps between patterns (small pitch sizes).

With the "LEEPL" apparatus, the sample and the mask are positioned close together (for example, with a separation of approximately 50 µm), and a parallel low-acceleration electron beam is then irradiated through the mask to transfer the pattern, and as the mask, a 1:1 mask is used.

As a result, another advantage of this method is that the mask production costs are lower than those for the masks used in photolithography reduced projection exposure methods. Furthermore, because the method is unaffected by the proximity effect, a high precision pattern can be formed.

The accelerating voltage of the low-acceleration electron beam is preferably within a range from 2 to 5 kV, and is most preferably 2 kV.

Subsequently, PEB (post exposure baking) is conducted under temperature conditions of 80 to 150°C for 40 to 120 seconds, and preferably for 60 to 90 seconds. Developing is then conducted using an alkali developing solution such as a 0.1 to 10% by weight aqueous solution of tetramethylammonium hydroxide. In this manner, a resist pattern that is faithful to the mask pattern can be obtained.

As described above, a positive resist composition for a low-acceleration electron beam according to the present invention can form a resist layer that exhibits superior etching resistance and reduced thickness loss when compared with conventional chemically amplified positive resist compositions that use polyhydroxystyrene-based resins.

Accordingly, the thickness of the resist layer can be reduced, meaning that the composition can be used effectively for generating a favorable pattern in a method for forming a resist pattern that includes an exposure step using a low-acceleration electron beam.

### [Three-Layer Resist Method]

In addition, because a positive resist composition for a low-acceleration electron beam according to the present invention enables a reduction in film thickness, it can also be used favorably as the positive resist layer that functions as the upper layer in a three-layer resist method.

In other words, in the production of semiconductors, when microprocessing is conducting by lithography methods using conventional chemically amplified resist materials, pattern formation of a single layer with a high aspect ratio has proven extremely difficult for mechanical strength reasons. As a result, a three-layer resist method in which the upper layer is a positive resist layer, the lower layer is an organic layer, and a thin-film metal layer is provided between the upper layer and lower layer as an interlayer has recently been proposed as a method that enables ready attainment of high dimensional precision and a high aspect ratio (for example, see Japanese Unexamined Patent Application, First Publication No. 2001-51422).

In a three-layer resist method, a pattern formed in the upper layer is used as a mask for conducting sequential etching of the interlayer with a halogen-based gas, and then the lower layer with an oxygen plasma, thereby transferring the pattern, and finally, this resist pattern is used as a mask for etching the pattern into the substrate using plasma etching with a fluorocarbon-based gas or the like. In the three-layer resist method, by providing an interlayer, the resist is able to function satisfactorily as a mask pattern, even if thickness loss occurs in the upper layer during plasma etching.

In the three-layer resist method, by using the lower layer (the organic layer) to ensure the desired thickness, the aspect ratio of the resist pattern can be increased and the desired level of dry etching resistance can be ensured, meaning that the thickness of the upper layer (the positive resist layer) can be reduced. As a result, even finer resist patterns can be formed.

### «Resist Laminate»

A resist laminate of the present invention contains a lower organic film layer and an interlayer that can be dry etched, and an upper resist film layer laminated on top of a substrate, and is used in a method of forming a resist pattern that includes a step of conducting exposure of the upper resist film layer using a low-acceleration electron beam. The term low-acceleration electron beam refers to the type of electron beam typically used in an aforementioned LEEPL process.

In the present invention, a positive resist composition for a low-acceleration electron beam that can be used favorably as the material for the upper resist film layer includes a resin component (A) (hereafter also referred to as the component (A)), which contains acid dissociable, dissolution inhibiting groups and exhibits increased alkali solubility under the action of acid, and an acid generator component (B) (hereafter also referred to as the component (B)) that generates acid on exposure.

In the component (A), the action of acid generated from the component (B) as a result of exposure causes the acid dissociable, dissolution inhibiting groups to dissociate, causing the entire component (A) to change from an alkali-insoluble state to an alkali-soluble state.

As a result, when the resist film layer is exposed through a mask pattern during the formation of a resist pattern, or alternatively, is exposed and then subjected to post exposure baking (PEB), the exposed portions shift to an alkali-soluble state, whereas the unexposed portions remain insoluble in alkali, meaning that alkali developing can then be used to form a positive resist pattern.

In the present invention, as the positive resist composition for a low-acceleration electron beam used in the upper resist film layer, a positive resist composition according to the aforementioned first aspect or second aspect yields a resist film which exhibits high resolution, excellent dry etching resistance and a reduced level of thickness loss, and is ideal for use within a method of forming a resist pattern that includes a step of conducting exposure using a low-acceleration electron beam, and is consequently preferred.

In other words, in electron beam lithography, the electron beam permeability of the resist layer is the most important factor. The electron beam permeability of the resist layer is influenced more by physical factors such as the film thickness of the resist layer than by the properties of the resist material, and furthermore, the permeability decreases as the accelerating voltage during electron beam irradiation is lowered. As a result, in those cases where a comparatively low accelerating voltage is used, such as a low-acceleration electron beam with an accelerating voltage of approximately 2 kV, a thin-film resist process is used to ensure adequate permeability of the resist layer by the electron beam. However, conventional resist materials exhibit insufficient dry etching resistance for use within thin-film resist processes, and suffer thickness loss during dry etching.

On the other hand, investigations by the inventors of the present invention discovered that a correlation existed between the dry etching resistance and thickness loss of the resist film, and the solubility of the resist in an alkali developing solution, and that by using a positive resist composition for a low-acceleration electron beam according to the aforementioned first aspect, in which the residual film ratio following alkali developing is at least 80%, a resist film could be obtained which offered significant improvements in the problems described above, and was ideal for use within a method of forming a resist pattern that includes a step of conducting exposure using a low-acceleration electron beam. Furthermore, a positive resist composition for a low-acceleration electron beam according to the aforementioned first aspect that used a resin containing specific structural units as the base resin also yields a resist film which offers significant improvements in the problems described above, and is ideal for use within a method of forming a resist pattern that includes a step of conducting exposure using a low-acceleration electron beam.

### {Interlayer}

There are no particular restrictions on the material used for the interlayer or the method used for forming the interlayer, and a material in which the silicon content within the polymer is within a range from 5 to 30%, and preferably from 5 to 15%, and a method that uses such a material, can be used. In terms of achieving favorable matching with a positive resist composition for a low-acceleration electron beam according to the second aspect of the present invention, a composition for forming a hard mask described below is ideal as the material for the interlayer.

### Composition for Forming Hard Mask

The composition for forming a hard mask (which also has an anti-reflective function, and can consequently also be referred to as a composition for forming an anti-reflective film) includes an alkali-soluble resin (A_{HM}) and a photoacid generator (B_{HM}), wherein the alkali-soluble resin (A_{HM}) contains a ladder-type silicone copolymer formed from structural units (s1), (s2), and (s3) described below.

Structural units (s1): (hydroxyphenylalkyl)silsesquioxane units, that is, structural units represented by a general formula (S-1) or (S-1') shown below.

Structural units (s2): (alkoxyphenylalkyl)silsesquioxane units, that is, structural units represented by a general formula (S-2) or (S-2') shown below.

Structural units (s3): alkyl or phenyl silsesquioxane units, that is, structural units represented by a general formula (S-3) or (S-3') shown below. 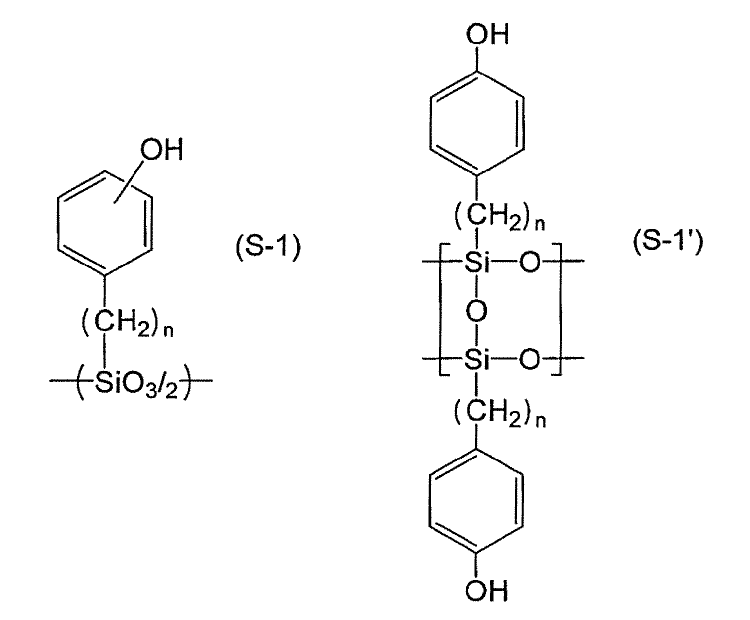 (wherein, n is an integer from 1 to 3) 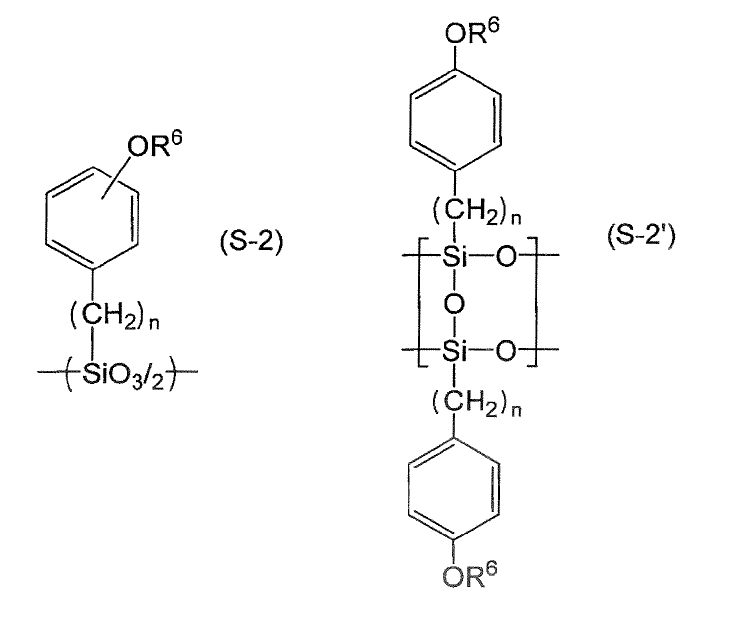 (wherein, R⁶ represents a straight-chain or branched lower alkyl group of 1 to 4 carbon atoms, and n is an integer from 1 to 3) 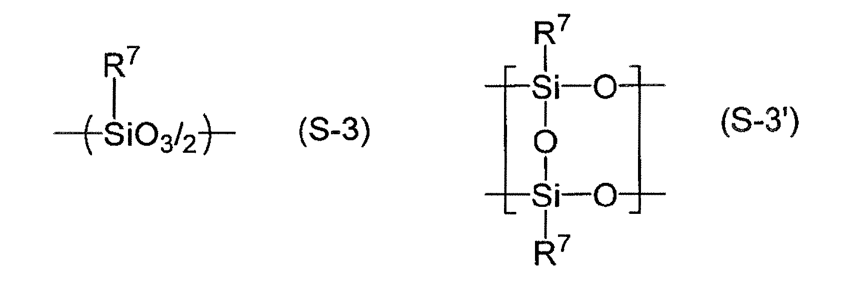 (wherein, R⁷ represents a straight-chain alkyl group of 1 to 20 carbon atoms, a branched alkyl group of 2 to 20 carbon atoms, a monocyclic or polycyclic alicyclic alkyl group of 5 to 20 carbon atoms, or a phenyl group)

The group R⁶ within the aforementioned general formulas (S-2) and (S-2') is most preferably a methyl group.

Furthermore, as the group R⁷ within the aforementioned general formula (S-3), a lower alkyl group of 1 to 5 carbon atoms, a cycloalkyl group of 5 to 6 carbon atoms, or a phenyl group enables ready adjustment of the k value (the extinction coefficient), and is consequently preferred.

Furthermore, the -OH group or -OR group within the aforementioned general formulas (S-1), (S-1'), (S-2), and (S-2') may be bonded at the o-position, the m-position or the p-position, although the p-position is preferred industrially.

Furthermore, the structural units (s1), (s2), and (s3) are typically represented by the aforementioned general formulas (S-1), (S-2), and (S-3), or the general formulas (S-1'), (S-2'), and (S-3').

This ladder-type silicone copolymer preferably has a weight average molecular weight (a polystyrene equivalent value) within a range from 1,500 to 20,000.

The relative proportions of these structural units are selected within ranges from 10 to 90 mol%, and preferably from 15 to 85 mol% for the structural units (s1), from 0 to 50 mol%, and preferably from 10 to 40 mol% for the structural units (s2), and from 1 to 90 mol%, and preferably from 15 to 85 mol% for the structural units (s3).

Of these structural units, the structural units (s2) control the degree of solubility within alkali, thereby suppressing thickness loss, and also prevent rounding of the cross-sectional shape of the resist pattern. These structural units are the same (alkoxyphenylalkyl)silsesquioxanes units that function as the starting material for the (hydroxyphenylalkyl)silsesquioxanes units, meaning that they can be introduced into the resin simply by inhibiting the degree of dissociation of the alkoxy groups.

The photoacid generator (B_{HM}) is a compound that generates acid on irradiation with light, and this type of compound has already been widely used as a component within conventional chemically amplified positive resist compositions, and in the present invention, any of these conventional compounds can be selected and used. Onium salts and diazomethane-based compounds are particularly preferred.

Examples of preferred photoacid generators (B_{HM}) include onium salts such as diphenyliodonium trifluoromethanesulfonate or nonafluorobutanesulfonate, bis(4-tert-butylphenyl)iodonium trifluoromethanesulfonate or nonafluorobutanesulfonate, triphenylsulfonium trifluoromethanesulfonate or nonafluorobutanesulfonate, tri(4-methylphenyl)sulfonium trifluoromethanesulfonate or nonafluorobutanesulfonate, and diazomethane-based compounds such as bis(p-toluenesulfonyl)diazomethane, bis(1,1= dimethylethylsulfonyl)diazomethane, bis(isopropylsulfonyl)diazomethane, bis(cyclohexylsulfonyl)diazomethane, and bis(2,4-dimethylphenylsulfonyl)diazomethane. Of these, onium salts with a decomposition point of no more than 250°C such as triphenylsulfonium trifluoromethanesulfonate, triphenylsulfonium nonafluorobutanesulfonate, or bis(p-tert-butylphenyl)iodonium 7,7-dimethyl-bicyclo-[2,2,1] -heptan-2-one-1-sulfonate are particularly preferred.

These photoacid generators (B_{HM}) can be used either alone, or in combinations of two or more different compounds. The quantity used is typically within a range from 0.5 to 20 parts by weight, and preferably from 1 to 10 parts by weight, per 100 parts by weight of the aforementioned alkali-soluble resin (A_{HM}). If the quantity of this photoacid generator is less than 0.5 parts by weight, image formation becomes difficult, whereas if the quantity exceeds 20 parts by weight, a uniform solution is unattainable, causing a deterioration in the storage stability.

In addition to the essential components described above (the alkali-soluble resin (A_{HM}) and the photoacid generator (B_{HM})), a cross-linking agent (C_{HM}) can also be added to the composition for forming a hard mask if required.

There are no particular restrictions on the types of cross-linking agent (C_{HM}) that can be used favorably within the composition for forming a hard mask, and any compound that is capable of causing cross-linking of the component (A_{HM}) to form a coating that is suitable as a hard mask when the composition for forming a hard mask is heated or calcined is suitable, although compounds containing two or more reactive groups, such as divinylbenzene, divinylsulfonic acid, triacrylformal, (meth)acrylate esters of glyoxal or polyhydric alcohols, and compounds in which at least two amino groups of melamine, urea, benzoguanamine or glycoluril have been substituted with methylol groups or lower alkoxymethyl groups. Of these compounds, cross-linking agents represented by the formulas shown below are the most desirable.

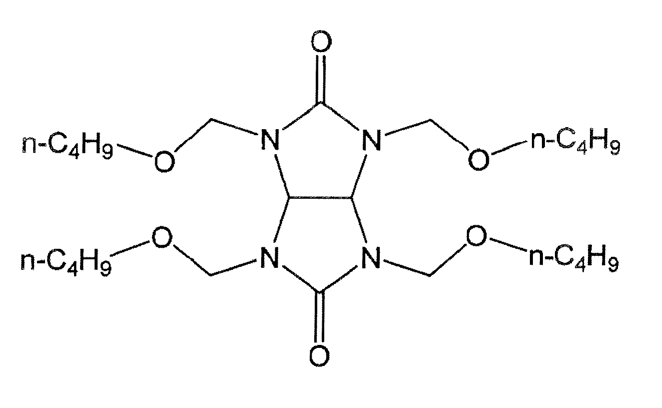

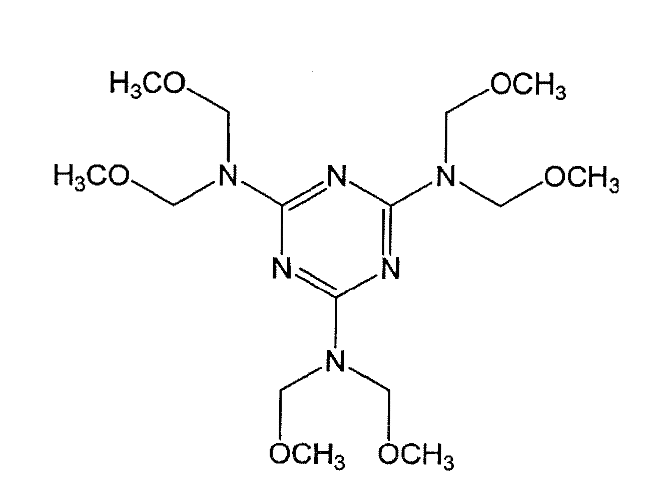

These cross-linking agents (C_{HM}) can be used in a quantity within a range from 1 to 10 parts by weight per 100 parts by weight of the component (A_{HM}).

In addition to the component (A_{HM}), component (B_{HM}), and component (C_{HM}) described above, a hard mask composition that can be used favorably in the present invention may also include, if required, a linear polymer as a component (D_{HM}).

As this linear polymer, a polyolefin, polystyrene, polyvinyl acetate, or polyamide or the like can be used, but an acrylic-based monomer is preferred, and an acrylic-based polymer in which adamantyl groups are bonded as side chains is particularly desirable.

Examples of this type of linear polymer include linear polymers containing from 10 to 60 mol%, and preferably from 20 to 40 mol% of units represented by a general formula (d₁): 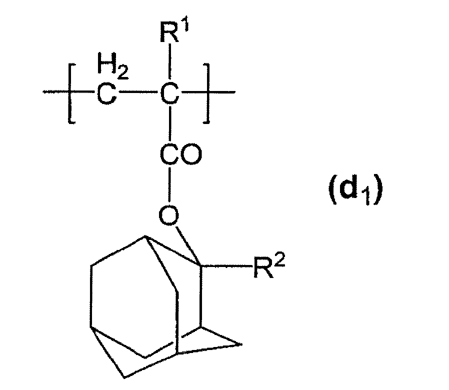 (wherein, R¹ represents a hydrogen atom or a methyl group, and R² represents a lower alkyl group), from 30 to 80 mol%, and preferably from 20 to 50 mol% of units represented by a general formula (d₂): 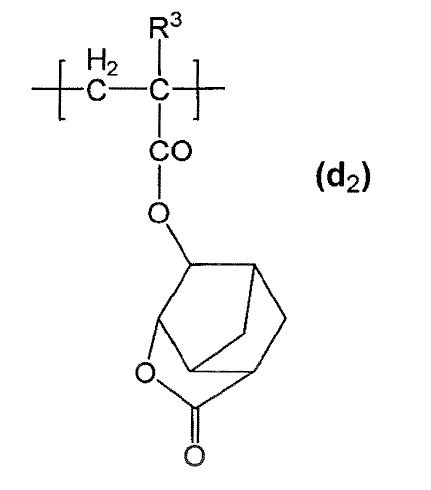 (wherein, R³ represents a hydrogen atom or a methyl group), and from 10 to 50 mol%, and preferably from 20 to 40 mol% of units represented by a formula (d₃): 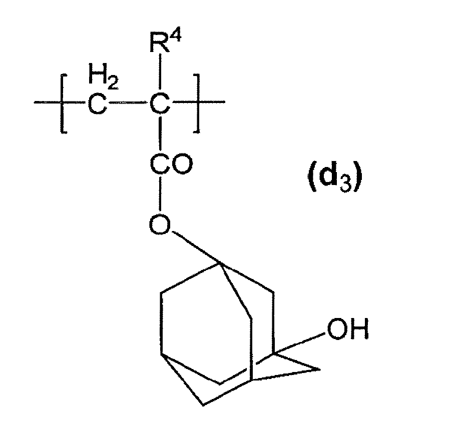 (wherein, R⁴ represents a hydrogen atom or a methyl group).

The R² group within the aforementioned general formula (d₁) is preferably a lower alkyl group of 1 to 5 carbon atoms, and from an industrial viewpoint, a methyl group or ethyl group is particularly desirable.

The weight average molecular weight of the linear polymer of this component (D_{HM}) is preferably within a range from 5,000 to 20,000.

This component (D_{HM}) is added in a quantity within a range from 10 to 100 parts by weight per 100 parts by weight of the component (A_{HM}).

In addition to the component (A_{HM}), component (B_{HM}), and component (C_{HM}) described above, and where added the component (D_{HM}), a hard mask composition that can be used favorably in the present invention may also include a conventional ionic or nonionic surfactant for imparting more favorable dispersibility and coating uniformity to the composition.

These surfactants are added in a proportion of 0.05 to 1.0 parts by weight per 100 parts by weight of the combined solid fraction of the composition.

The composition for forming a hard mask used in the present invention can be applied with ease, using a conventional spin coating method, to the surface of a substrate such as a silicon wafer containing an organic film as a base material, thereby forming the desired anti-reflective film. Considering that conventional resist processes have required the formation of an oxide film on a substrate using vapor deposition, followed by formation of a resist film on top of the oxide film, the composition of the present invention offers a significant simplification of the process.

In order to form this hard mask, the use of a multi-stage calcinations method is ideal, wherein the hard mask composition is spin coated onto a substrate, dried, and then calcined at a temperature no higher than the boiling point of the solvent, for example a temperature of 100 to 120°C, for a period of 60 to 120 seconds, and then at a temperature of 200 to 250°C for a period of 60 to 120 seconds. In this manner, a hard mask with a thickness within a range from 10 to 100 nm, and preferably from 20 to 80 nm is formed, and normal methods can then be used to provide a resist film with a thickness of 50 to 150 nm, and preferably from 50 to 100 nm, on top of the hard mask, thus completing production of a multi-layer resist laminate. With this method, by first providing an organic film with a thickness of 50 to 500 nm, and preferably from 100 to 400 nm, on top of the substrate, and then forming the aforementioned hard mask (the anti-reflective film) as an interlayer between the organic film and the resist film, a three-layer multi-layer resist laminate can be produced.

The composition for forming a hard mask is dissolved in a suitable solvent prior to use, and used in the form of a solution. The solvent used can employ the same solvents as those described above for the component (C).

Other compatible additives can also be added to the composition for forming a hard mask, according to need, and examples include conventionally used additives such as sensitizers, additive resins, plasticizers, stabilizers, and colorants used for making the developed image more visible.

An interlayer can be formed by applying a solution of the composition for forming a hard mask described above to a lower organic film layer described below using normal methods.

### {Lower Organic Film Layer}

The lower organic film layer is an organic film that is able to be etched using conventional dry etching methods. This organic film is preferably insoluble in the alkali developing solution used for post-exposure developing. With this type of lower organic film layer, first, lithography using a low-acceleration electron beam is used to selectively expose the upper resist film layer and alkali developing is conducted to form a resist pattern, and by subsequently using this resist pattern as a mask to transfer the pattern to the interlayer using oxide etching with a halogen-based gas or the like, and then conducting dry etching of the lower organic film layer using the pattern in the interlayer as a mask, the resist pattern of the upper resist film layer and the interlayer is transferred to the lower organic film layer. As a result, a pattern with a high aspect ratio can be formed without pattern collapse.

The organic film material for forming the lower organic film layer does not necessarily require the sensitivity to electron beams or light needed for the upper resist film layer. The resists and resins typically used in the production of semiconductor elements and liquid crystal display elements can be used.

Furthermore, because the upper layer resist pattern and the interlayer pattern must be transferred to the lower organic film layer, the lower organic film layer should preferably be formed from a material that is able to be etched by oxygen plasma etching.

As this type of material, materials containing at least one resin selected from a group consisting of novolak resins, acrylic resins, and soluble polyimides as the primary component are preferred, as they are readily etched by oxygen plasma treatment, and also display good resistance to fluorocarbon-based gases, which are used in subsequent processes for tasks such as etching the silicon substrate.

Of these materials, novolak resins, and acrylic resins containing alicyclic regions or aromatic rings on side chains are cheap, widely used, and exhibit excellent resistance to the dry etching of subsequent processes, and are consequently preferred.

As the novolak resin, any of the resins typically used in positive resist compositions can be used, and positive resists for i-line or g-line radiation containing a novolak resin as the primary component can also be used.

A novolak resin is a resin obtained, for example, by an addition condensation of an aromatic compound containing a phenolic hydroxyl group (hereafter, simply referred to as a phenol compound) and an aldehyde, in the presence of an acid catalyst.

Examples of the phenol compound include phenol, o-cresol, m-cresol, p-cresol, o-ethylphenol, m-ethylphenol, p-ethylphenol, o-butylphenol, m-butylphenol, p-butylphenol, 2,3-xylenol, 2,4-xylenol, 2,5-xylenol, 2,6-xylenol, 3,4-xylenol, 3,5-xylenol, 2,3,5-trimethylphenol, 3,4,5-trimethylphenol, p-phenylphenol, resorcinol, hydroquinone, hydroquinone monomethyl ether, pyrogallol, fluoroglycinol, hydroxydiphenyl, bisphenol A, gallic acid, gallic esters, α-naphthol, and β-naphthol.

Furthermore, examples of the aldehyde include formaldehyde, furfural, benzaldehyde, nitrobenzaldehyde, and acetaldehyde.

There are no particular restrictions on the catalyst used in the addition condensation reaction, and suitable acid catalysts include hydrochloric acid, nitric acid, sulfuric acid, formic acid, oxalic acid, and acetic acid.

The weight average molecular weight of the novolak resin is typically within a range from 3,000 to 10,000, and preferably from 6,000 to 9,000, and most preferably from 7,000 to 8,000. If the weight average molecular weight is less than 3,000, then the resin may sublime when baked at high temperatures, whereas if the weight average molecular weight exceeds 10,000, the resin tends to become more difficult to dry etch, which is undesirable.

Novolak resins for use in the present invention can use commercially available resins, although novolak resins with a weight average molecular weight (Mw) within a range from 5,000 to 50,000, and preferably from 8,000 to 30,000, in which the quantity of low molecular weight materials with a molecular weight of no more than 500, and preferably no more than 200, as measured by gel permeation chromatography, is no more than 1% by weight, and preferably 0.8% by weight or less, are preferred. The low molecular weight fraction is preferably as small as possible, and is most preferably 0% by weight.

The low molecular weight materials with a molecular weight of no more than 500 are detected as a low molecular weight fraction of molecular weight 500 or less during GPC analysis using polystyrene standards. These low molecular weight materials with a molecular weight of no more than 500 include unpolymerized monomers, and low polymerization degree materials, which vary depending on the molecular weight, but include, for example, materials produced by the condensation of 2 to 5 phenol molecules with an aldehyde.

The quantity (weight %) of this low molecular weight fraction with a molecular weight of no more than 500 is measured by graphing the results of the above GPC analysis, with the fraction number across the horizontal axis and the concentration along the vertical axis, and then determining the ratio (%) of the area under the curve within the low molecular weight fraction for molecular weights of no more than 500, relative to the area under the entire curve.

By ensuring that the Mw of the novolak resin is no more than 50,000, more favorable filling characteristics can be obtained for substrates with very fine indentations, and furthermore, by ensuring that the molecular weight is at least 5,000, a superior level of resistance to etching by fluorocarbon-based gases and the like can be achieved.

Furthermore, ensuring that the quantity of low molecular weight materials with a molecular weight of no more than 500 is no more than 1% by weight produces more favorable filling characteristics for substrates with very fine indentations. The reason that such a reduction in the low molecular weight fraction should improve the filling characteristics remains unclear, although it is surmised that it is a reflection of the reduced dispersity.

As the acrylic resin, any of the resins typically used in positive resist compositions can be used, and suitable examples include acrylic resins containing structural units derived from a polymerizable compound with an ether linkage, and structural units derived from a polymerizable compound containing a carboxyl group.

Examples of the polymerizable compound containing an ether linkage include (meth)acrylic acid derivatives containing both an ether linkage and an ester linkage such as 2-methoxyethyl (meth)acrylate, methoxytriethylene glycol (meth)acrylate, 3-methoxybutyl (meth)acrylate, ethylcarbitol (meth)acrylate, phenoxypolyethylene glycol (meth)acrylate, methoxypolypropylene glycol (meth)acrylate, and tetrahydrofurfuryl (meth)acrylate. These compounds can be used either alone, or in combinations of two or more different compounds.

Examples of the polymerizable compound containing a carboxyl group include monocarboxylic acids such as acrylic acid, methacrylic acid, and crotonic acid; dicarboxylic acids such as maleic acid, fumaric acid, and itaconic acid; and compounds containing both a carboxyl group and an ester linkage such as 2-methacryloyloxyethylsuccinic acid, 2-methacryloyloxyethylmaleic acid, 2-methacryloyloxyethylphthalic acid, and 2-methacryloyloxyethylhexahydrophthalic acid, although of these, acrylic acid and methacrylic acid are preferred. These compounds can be used either alone, or in combinations of two or more different compounds.

The soluble polyimide refers to polyimides that can be converted to liquid form in the type of organic solvents described above.

The lower organic film layer can be formed, for example, by applying a solution of the type of base material described above to the surface of a substrate using normal methods.

### <Substrate>

As the substrate, conventional materials can be used without any particular restrictions, and suitable examples include substrates for electronic componentry, as well as substrates on which a predetermined wiring pattern has already been formed.

Specific examples of suitable substrates include metal-based substrates such as silicon wafers, copper, chrome, iron, and aluminum, as well as glass substrates.

Suitable materials for the wiring pattern include copper, aluminum, nickel, and gold.

### {Film Thickness of Each Layer}

In a resist laminate of the present invention, giving due consideration to the ideal balance between the targeted aspect ratio and the throughput, which is affected by the dry etching time required for the lower organic film layer, the combined thickness of the upper resist film layer, the interlayer, and the lower organic film layer is preferably a total of no more than 1 µm, even more preferably no more than 0.7 µm, and most preferably no more than 0.5 µm. There are no particular restrictions on the lower limit for this combined thickness, although values of at least 0.1 µm are preferred, and values of 0.15 µm or greater are even more desirable.

The thickness of the upper resist film layer is preferably within a range from 50 to 150 nm, and even more preferably from 50 to 100 nm. By ensuring that the thickness of the upper resist film layer falls within this range, a satisfactory level of permeability to low-acceleration electron beams can be achieved. Furthermore, the resist pattern can be formed with a high level of resolution, and a satisfactory level of resistance to dry etching can also be achieved.

The thickness of the interlayer is preferably within a range from 10 to 100 nm, and even more preferably from 20 to 80 nm. By ensuring that the thickness of the interlayer falls within this range, the resist pattern can be formed with a high level of resolution, and a satisfactory level of resistance to dry etching can also be achieved.

The thickness of the lower organic film layer is preferably within a range from 50 to 500 nm, and even more preferably from 100 to 400 nm. By ensuring that the thickness of the lower organic film layer falls within this range, a resist pattern with a high aspect ratio can be formed, and a satisfactory level of etching resistance to subsequent substrate etching can also be ensured.

The resist laminate of the present invention includes both laminates in which a resist pattern has been formed in the upper resist film layer, the interlayer, and the lower organic film layer, as well as laminates in which no resist pattern has been formed.

### «Method of Pattern Formation»

A method of pattern formation according to the present invention involves sequentially conducting a laminate formation step of forming an aforementioned resist laminate of the present invention, a step of conducting exposure of the aforementioned upper resist film layer of the resist laminate using a low-acceleration electron beam, and then conducting alkali developing to form a resist pattern in the upper resist film layer, a step of conducting oxide etching using the resist pattern as a mask pattern, thereby transferring the pattern to the aforementioned interlayer, and a step of conducting dry etching of the aforementioned lower organic film layer using the resist pattern and the pattern within the interlayer as a mask pattern, thereby forming a lower layer pattern within the lower organic film layer.

A method of pattern formation according to the present invention can be conducted, for example, in the manner described below.

### <Laminate Formation Step>

First, a resist composition or resin solution for forming the lower organic film layer is applied to the top of a substrate such as a silicon wafer using a spinner or the like, and a prebake treatment is then performed, preferably at a temperature of 200 to 300°C, for a period of 30 to 300 seconds, and preferably for 60 to 180 seconds, thus forming a lower organic film layer.

Subsequently, an aforementioned composition for forming a hard mask is applied to the surface of the lower organic film layer using a spinner or the like, and is then subjected to a multi-stage calcination by conducting calcinations, for example, at a temperature of 100 to 120°C for a period of 60 to 120 seconds, and then at a temperature of 200 to 250°C for a period of 60 to 120 seconds. In this manner, a hard mask with a thickness of 10 to 100 nm, and preferably from 20 to 80 nm is formed as the interlayer.

Next, a resist composition solution containing a positive resist composition for a low-acceleration electron beam according to either of the aforementioned first and second aspects is applied to the surface of the interlayer using a spinner or the like, and a prebake treatment is then performed at a temperature of 80 to 150°C for a period of 40 to 120 seconds, and preferably for 60 to 90 seconds, thereby forming an upper resist film layer and completing preparation of a resist laminate in which a resist with a three-layer structure has been laminated on top of the substrate.

### <Pattern Formation Step>

Subsequently, the upper resist film layer of this resist laminate may be patterned by direct irradiation with a low-acceleration electron beam without using a mask, but is preferably selectively exposed through a desired mask pattern using a low-acceleration electron beam exposure apparatus such as "LEEPL" (a product name, manufactured by Leepl Corporation, accelerating voltage: 2 kV). Conducting the exposure through a mask pattern provides certain advantages, including an improvement in the throughput, and the ability to form resist patterns with small gaps between patterns (small pitch sizes).

With the "LEEPL" apparatus, the sample and the mask are positioned close together (for example, with a separation of approximately 50 µm), and a parallel low-acceleration electron beam is then irradiated through the mask to transfer the pattern, and as the mask, a 1:1 mask is used.

As a result, another advantage of this method is that the mask production costs are lower than those for the masks used in photolithography reduced projection exposure methods. Furthermore, because the method is unaffected by the proximity effect, a high precision pattern can be formed.

The accelerating voltage of the low-acceleration electron beam is preferably within a range from 2 to 5 kV, and is most preferably 2 kV.

Subsequently, PEB (post exposure baking) is conducted under temperature conditions of 80 to 150°C for 40 to 120 seconds, and preferably for 60 to 90 seconds. The resist laminate is then developed using an alkali developing solution such as a 0.1 to 10% by weight aqueous solution of tetramethylammonium hydroxide. In this manner, a resist pattern (the upper layer resist pattern) that is faithful to the mask pattern can be formed in the upper resist film layer.

Using this resist pattern as a mask pattern, the pattern (the interlayer pattern) is then transferred to the interlayer. Formation of the interlayer pattern is conducted by oxide etching the interlayer with an interlayer etchant (a gas capable of etching the interlayer, such as a halogen-based gas in the case of a interlayer formed from a silicon-based coating) using the upper layer resist pattern as a mask. These etchants and the associated etching conditions can be selected in accordance with conventional methods.

Next, the resist pattern and the interlayer pattern (the hard mask pattern) are used as a mask pattern, and by conducting dry etching of the lowest organic layer using oxygen gas, such as etching by a plasma etching method or reactive ion etching method, a resist pattern that is faithful to the mask pattern can be obtained.

Subsequently, the thus formed pattern (mainly the interlayer pattern and the organic layer pattern) is typically used as a mask for etching the substrate, and those portions of the substrate not coated with the resist are selectively removed.

As the dry etching method, conventional methods including chemical etching such as down-flow etching or chemical dry etching; physical etching such as sputter etching or ion beam etching; or chemical-physical etching such as RIE (reactive ion etching) can be used.

The most typical type of dry etching is parallel plate RIE. In this method, first, the resist laminate is placed inside the RIE apparatus chamber, and the required etching gas is introduced. A high frequency voltage is then applied within the chamber, between an upper electrode and the resist laminate holder which is positioned parallel to the electrode, and this causes the generation of a gas plasma. The plasma contains charged particles such as positive and negative ions and electrons, as well as electrically neutral active seeds. As these etching seeds adsorb to the lower resist layer, a chemical reaction occurs, and the resulting reaction product breaks away from the surface and is discharged externally, causing the etching to proceed.

As the etching gas, oxygen or sulfur dioxide or the like are suitable, although oxygen plasma etching provides a high level of resolution and is widely used, and is consequently preferred.

By using the lower layer pattern obtained in the manner described above as a mask for conducting etching of the substrate, a fine pattern can be formed within the substrate. The pattern obtained in the manner described above can then be used, for example, in the production of semiconductors or the like, as described below.

As the etching method, an etching method that uses a halogen-based gas is particularly preferred.

As described above, a positive resist composition for a low-acceleration electron beam according to the present invention exhibits excellent dry etching resistance and a reduced level of thickness loss, meaning that it generates a high resolution resist pattern, and can be used favorably within a method of forming a resist pattern that includes a step of conducting exposure using a low-acceleration electron beam.

In the three-layer resist method, the upper layer must generally be able to be formed as a thin layer, as well as exhibiting superior dry etching resistance and favorable matching with the interlayer. A positive resist composition for a low-acceleration electron beam according to the present invention exhibits excellent dry etching as well as favorable matching with most commonly used interlayers, and particularly with interlayers formed using the type of composition for forming a hard mask described above, and also generates a high resolution resist pattern, and as such, can be used very favorably within the three-layer resist method.

### EXAMPLES

As follows is a more detailed description of the present invention using a series of examples.

### Reference Example

A method of preparing a composition for forming a hard mask is detailed below.

Using a copolymer (with a weight average molecular weight of 7,000) formed from 72 mol% of p-hydroxybenzylsilsesquioxane units and 28 mol% of phenylsilsesquioxane units as the component (A_{HM}), a mixture containing 100 parts by weight of this component (A_{HM}), 3 parts by weight of bis(p-tert-butylphenyl)iodonium 7,7-dimethyl-bicyclo-[2,2,1]-heptan-2-one-1-sulfonate as the component (B_{HM}), 5 parts by weight of tetrabutoxymethylglycoluril as a cross-linking agent, and 35 parts of an acrylate-type polymer represented by the chemical formulas (VI) shown below as a linear polymer was dissolved in 300 parts by weight of a mixture of propylene glycol monoether monoacetate and propylene glycol monopropyl ether (weight ratio: 6.2/93.8), thereby yielding a composition for forming a hard mask.

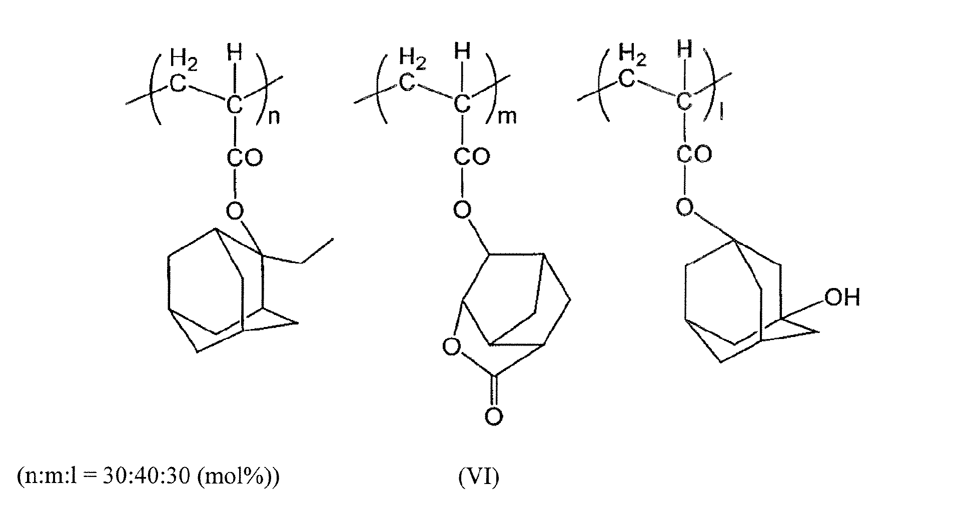

### [Example 1]

First, a component (A'2) was prepared. Namely, p-hydroxystyrene and adamantanol methacrylate, which gives rise to a structural unit of the above general formula (IVa) in which R is a methyl group, were reacted together by normal polymerization methods in the presence of an acid catalyst, thereby yielding a copolymer (molar ratio: 80:20, weight average molecular weight (Mw): 8,000, dispersity (Mw/Mn): 1.2). This copolymer and ethyl vinyl ether were then reacted together by normal methods in the presence of an acid catalyst, thus forming a resin (X) in which the hydrogen atoms of some of the hydroxyl groups of the copolymer had been protected with 1-ethoxyethyl groups.

Analysis of this resin (X) by ¹H-NMR revealed that the quantity of 1-ethoxyethoxy groups relative to the total number of hydroxyl groups within the p-hydroxystyrene and adamantanol was 25%. This indicates a protection ratio for the hydroxyl groups of 25 mol%. Furthermore, the value of Mw for the resin (X) was 10,000, and the value of Mw/Mn was 1.2.

Using this resin (X) as the component (A'2), a mixture of 100 parts by weight of this component (A'2), 8 parts by weight of triphenylsulfonium trifluoromethanesulfonate as the component (B), 0.8 parts by weight of trioctylamine as the component (D), and 0.32 parts by weight of salicylic acid as the component (E) were dissolved in propylene glycol monomethyl ether acetate (hereafter abbreviated as PM), thus yielding a positive resist composition for a low-acceleration electron beam with a solid fraction concentration of 3.5% by weight.

The thus obtained positive resist composition for a low-acceleration electron beam was applied to the surface of a silicon wafer using a spinner, and was then subjected to a soft bake treatment at 100°C for 90 seconds, thereby forming a positive resist layer with a film thickness of 70 nm.

Subsequently, the resist layer was subjected to post exposure baking (PEB) treatment at 110°C for 90 seconds, and was then subjected to puddle development for 60 seconds at 23°C in a 2.38% by weight aqueous solution of tetramethylammonium hydroxide (TMAH), and then rinsed with pure water for 30 seconds. The resist was then shaken dry and further dried by heating at 100°C for 60 seconds, and when the film thickness of the positive resist layer was then measured, the result was 67 nm. This result indicates a residual film ratio of 95%.

Furthermore, the positive resist composition for a low-acceleration electron beam was also applied uniformly, with a film thickness of 70 nm, to the surface of an 8-inch silicon substrate that had been treated with hexamethyldisilazane, and was then subjected to at 100°C for 90 seconds, thus forming a resist film. Subsequently, the substrate was subjected to a mask transfer using a low-acceleration electron beam exposure apparatus "LEEPL" (manufactured by Leepl Corporation, accelerating voltage: 2 kV), and the resist layer was then subjected to baking at 110°C for 90 seconds, developing for 60 seconds in a 2.38% by weight aqueous solution of TMAH, and rinsing with pure water for 30 seconds, before the substrate was shaken dry and then subjected to further baking at 100°C for 60 seconds. Using this process, a line and space (L/S) pattern with a resolution of 80 nm and a contact hole (C/H) pattern with a resolution of 80 nm were obtained. Defects were measured using a surface defect inspection apparatus KLA2132 (a product name), manufactured by KLA Tencor Corporation, and evaluation of the number of defects on the wafer revealed no defects.

Subsequently, using the L/S pattern with a line width of 80 nm formed above as a mask, an etching rate test was conducted in which the substrate was subjected to dry etching. In other words, when the etching rate was measured using a mixed gas of oxygen and tetrafluoromethane as the etching gas, the etching rate was 1.2 times slower than the rate measured under the same conditions in the comparative example 1 described below, indicating an excellent level of etching resistance.

### [Example 2]

With the exception of replacing the adamantanol methacrylate used in the synthesis of the component (A'2) in the example 1 with adamantanol acrylate, which gives rise to a structural unit of the above general formula (IVa) in which R is a hydrogen atom, preparation was conducted in the same manner as the example 1, and yielded a resin (Y) in which some of the hydroxyl groups of the copolymer (molar ratio: 80:20, weight average molecular weight (Mw): 7,700, dispersity (Mw/Mn): 1.2) had been protected with 1-ethoxyethyl groups.

Analysis of this resin (Y) by ¹H-NMR revealed that the quantity of 1-ethoxyethoxy groups relative to the total number of hydroxyl groups within the p-hydroxystyrene and adamantanol was 30%. This indicates a protection ratio for the hydroxyl groups of 30 mol%. Furthermore, the value of Mw for the resin (Y) was 9,700, and the value of Mw/Mn was 1.2.

Subsequently, with the exception of using the resin (Y) instead of the resin (X), a positive resist composition for a low-acceleration electron beam was prepared in the same manner as the example 1, and the residual film ratio was measured. The measurement result revealed a residual film ratio of 95%.

Furthermore, using the thus obtained positive resist composition for a low-acceleration electron beam, a resist pattern was formed in the same manner as the example 1. As a result, a line and space (L/S) pattern with a resolution of 80 nm and a contact hole (C/H) pattern with a resolution of 80 nm were obtained. Defects were measured using a surface defect inspection apparatus KLA2132 (a product name), manufactured by KLA Tencor Corporation, and evaluation of the number of defects on the wafer revealed no defects.

Furthermore, when the etching rate was measured in the same manner as the example 1, the etching rate was 1.2 times slower than the rate measured under the same conditions in the comparative example 1 described below, indicating an excellent level of etching resistance.

### [Example 3]

First, a component (A'1) was prepared. Namely, poly(p-hydroxystyrene) (weight average molecular weight (Mw): 8,000, dispersity (Mw/Mn): 1.2) and adamantoxy vinyl ether were reacted together by conventional methods in the presence of an acid catalyst, thereby yielding a resin (Z) in which the hydrogen atoms of a portion of the hydroxyl groups of the poly(p-hydroxystyrene) had been protected with acid dissociable, dissolution inhibiting groups represented by the aforementioned formula (II-a).

Analysis of this resin (Z) by ¹H-NMR revealed that the quantity of the acid dissociable, dissolution inhibiting groups represented by the formula (II-a) relative to the number of p-hydroxystyrene hydroxyl groups was 30%. This indicates a protection ratio for the hydroxyl groups of 30 mol%. Furthermore, the value of Mw for the resin (Z) was 12,000, and the value ofMw/Mn was 1.2.

Subsequently, with the exception of using this resin (A'1) as the component (A), a positive resist composition for a low-acceleration electron beam was prepared in the same manner as the example 1, and the residual film ratio was measured. The measurement result revealed a residual film ratio of 95%.

Furthermore, using the thus obtained positive resist composition for a low-acceleration electron beam, a resist pattern was formed in the same manner as the example 1. As a result, a line and space (L/S) pattern with a resolution of 80 nm and a contact hole (C/H) pattern with a resolution of 80 nm were obtained. Defects were measured using a surface defect inspection apparatus KLA2132 (a product name), manufactured by KLA Tencor Corporation, and evaluation of the number of defects on the wafer revealed no defects.

Furthermore, when the etching rate was measured in the same manner as the example 1, the etching rate was 1.4 times slower than the rate measured under the same conditions in the comparative example 1 described below, indicating an excellent level of etching resistance.

### [Example 4]

With the exception of replacing the poly(p-hydroxystyrene) used in the synthesis of the component (A) in the example 3 with a copolymer of p-hydroxystyrene and styrene (molar ratio: 85:15, weight average molecular weight (Mw): 8,000, dispersity (Mw/Mn): 1.2), preparation was conducted in the same manner as the example 3, and yielded a resin (W) in which the hydrogen atoms of a portion of the hydroxyl groups of the p-hydroxystyrene structural units contained within the copolymer had been protected with acid dissociable, dissolution inhibiting groups represented by the aforementioned formula (II-a).

Analysis of this resin (W) by ¹H-NMR revealed that the quantity of the acid dissociable, dissolution inhibiting groups represented by the formula (II-a) relative to the number of p-hydroxystyrene hydroxyl groups was 25%. This indicates a protection ratio for the hydroxyl groups of 25 mol%. Furthermore, the value of Mw for the resin (W) was 10,000, and the value of Mw/Mn was 1.2.

Subsequently, with the exception of using this resin (A1) as the component (A), a positive resist composition for a low-acceleration electron beam was prepared in the same manner as the example 1, and the residual film ratio was measured. The measurement result revealed a residual film ratio of 95%.

Furthermore, using the thus obtained positive resist composition for a low-acceleration electron beam, a resist pattern was formed in the same manner as the example 1. As a result, a line and space (L/S) pattern with a resolution of 80 nm and a contact hole (C/H) pattern with a resolution of 80 nm were obtained. Defects were measured using a surface defect inspection apparatus KLA2132 (a product name), manufactured by KLA Tencor Corporation, and evaluation of the number of defects on the wafer revealed no defects.

Furthermore, when the etching rate was measured in the same manner as the example 1, the etching rate was 1.4 times slower than the rate measured under the same conditions in the comparative example 1 described below, indicating an excellent level of etching resistance.

### [Comparative Example 1]

With the exception of replacing the resin (X) that functions as the component (A) in the example 1 with a resin component comprising poly(p-hydroxystyrene) (weight average molecular weight: 8,000, dispersity: 1.2) in which a portion of the hydroxyl groups have been protected with 1-ethoxyethyl groups (hydroxyl group protection ratio: 35 mol%), a conventionally known positive resist composition was prepared, and the residual film ratio was measured, in the same manner as the example 1.

The measurement result revealed a residual film ratio of 75%.

Furthermore, using the thus obtained positive resist composition, a resist pattern was formed in the same manner as the example 1. As a result, a line and space (L/S) pattern with a resolution of 90 nm and a contact hole (C/H) pattern with a resolution of 90 nm were obtained, but the tops of the patterns were rounded while the residual film ratio of the unexposed portions was large, resulting in an unsatisfactory pattern.

### [Examples 5 to 8, Comparative Example 2]

Using the positive resist compositions obtained in the examples 1 to 4 and the comparative example 1, resist patterns were formed using the procedure described below.

First, a solution of a commercially available base material (product name: TBLC-100, manufactured by Tokyo Ohka Kogyo Co., Ltd.) was applied to the surface of an 8-inch silicon wafer using a spinner, and this solution was then soft baked at 230°C for 90 seconds, thus forming an organic layer (the lower layer) with a film thickness of 300 nm.

Subsequently, the composition for forming a hard mask described above was applied to the lower layer, and was soft baked at 100°C for 90 seconds, and then baked at 250°C for 90 seconds, thereby forming a hard mask (the interlayer) with a film thickness of 55 nm.

A positive resist composition obtained in one of the examples 1 to 4 or the comparative example 1 was then applied to the interlayer using a spinner, and was then soft baked at 100°C for 90 seconds, thereby forming a positive resist layer (the upper layer) with a film thickness of 70 nm and completing preparation of a laminate in which a resist layer with a three-layer structure had been laminated on top of the substrate.

Subsequently, the laminate was irradiated with a low-acceleration electron beam with an accelerating voltage of 2 kV, through a desired mask pattern, using a low-acceleration electron beam exposure apparatus "LEEPL" (a product name, manufactured by Leepl Corporation, accelerating voltage: 2 kV), and the resist layer was then subjected to post exposure baking (PEB) at 110°C for 90 seconds, subjected to developing for 60 seconds at 23°C in a 2.38% by weight aqueous solution of tetramethylammonium hydroxide, and was then rinsed with pure water for 30 seconds. The laminate was then shaken dry and subjected to further drying at 100°C for 60 seconds, thereby completing formation of a C/H pattern with a hole diameter of 70 nm in the upper layer.

Using the thus obtained resist pattern as a mask pattern, the interlayer was subjected to oxide etching using an oxide etching apparatus (TCE-7811X, manufactured by Tokyo Ohka Kogyo Co., Ltd.), under conditions including a pressure of 300 mTorr, CF₄/CHF₃/He = 75/45/200 (sccm), an output of 1200 W, an upper treatment temperature of 25°C and a lower treatment temperature of 20°C, thereby transferring the resist pattern to the interlayer. Using the resist pattern and the interlayer as a mask, the lower layer was then subjected to reactive ion etching using a parallel plate plasma etching apparatus (GP2, manufactured by Tokyo Ohka Kogyo Co., Ltd.), under conditions including a pressure of 0.4 Pa, an oxygen and nitrogen mixed gas flow rate of 20 cc/min., RF output of 1,000 W, and a treatment temperature of 25°C, thereby forming a resist pattern in the lower layer.

Inspection of the thus obtained resist patterns using a SEM (scanning electron microscope) revealed that the resists of the examples 5 to 8 exhibited less thickness loss than the resist of the comparative example 2. From this result it is evident that the present invention offers favorable etching resistance.

Furthermore, the cross-sectional shapes of the C/H patterns in the examples 5 and 6 were very favorable with a high degree of rectangularity, and the C/H patterns with a line width of 70 nm had been formed with favorable resolution. The cross-sectional shapes of the C/H patterns in the examples 7 and 8 revealed a slight inverted taper, but at a level that is unproblematic from a practical viewpoint. The reason this type of shape was formed is thought to reflect reduced solubility at the resist surface caused by the presence of the bulky and highly hydrophobic acid dissociable, dissolution inhibiting groups.

In contrast, the resist pattern of the comparative example 2 exhibited severe thickness loss, and the cross-sectional shape of the C/H pattern exhibited top rounding around the periphery of the holes. Furthermore, a C/H pattern with a line width of 70 nm could not be formed.

## Claims

1. A positive resist composition for a low-acceleration electron beam, comprising a resin component (A), which contains acid dissociable, dissolution inhibiting groups and exhibits increased alkali solubility under action of acid, and an acid generator component (B) that generates acid on exposure, wherein
a residual film ratio following alkali developing in unexposed portions of a resist film formed from said positive resist composition for a low-acceleration electron beam is 80% or higher.

2. A positive resist composition for a low-acceleration electron beam, comprising a resin component (A'), which contains alkali-soluble structural units (a1) and structural units (a2) that contain an acid dissociable, dissolution inhibiting group, and exhibits increased alkali solubility under action of acid, and an acid generator component (B) that generates acid on exposure, wherein
at least one of said structural units (a1) and (a2) within said resin component (A') contains a polycyclic group.

3. A positive resist composition for a low-acceleration electron beam according to claim 2, wherein said structural units (a1) comprise structural units (a11) represented by a general formula (I) shown below: 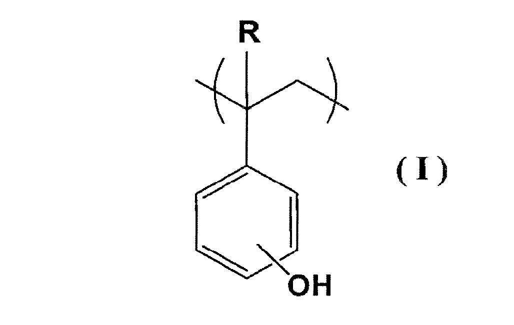 [wherein, R represents a hydrogen atom or a methyl group].

4. A positive resist composition for a low-acceleration electron beam according to claim 3, wherein said resin component (A') is a polymer (A'1) containing said structural units (a11), and structural units (a21), in which hydrogen atoms of a portion of hydroxyl groups of said structural units (a11) are protected with acid dissociable, dissolution inhibiting groups represented by a general formula (II) shown below: 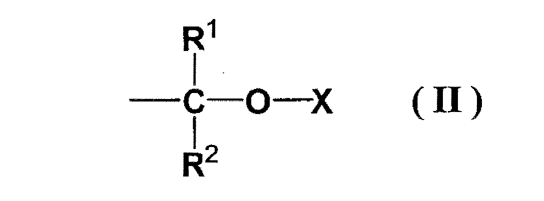 [wherein, R¹ represents an alkyl group of 1 to 5 carbon atoms, R² represents an alkyl group of 1 to 5 carbon atoms or a hydrogen atom, and X represents an aliphatic polycyclic group or an aromatic polycyclic hydrocarbon group].

5. A positive resist composition for a low-acceleration electron beam according to claim 4, wherein said polymer (A'1) further comprises structural units (a3) represented by a general formula (III) shown below: 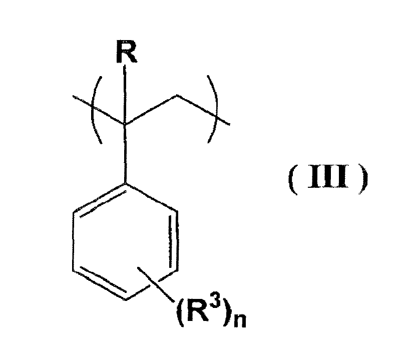 [wherein, R represents a hydrogen atom or a methyl group, R³ represents an alkyl group of 1 to 5 carbon atoms, and n represents either 0 or an integer of 1 to 3].

6. A positive resist composition for a low-acceleration electron beam according to claim 4, wherein R within said general formula (I) is a hydrogen atom.

7. A positive resist composition for a low-acceleration electron beam according to claim 4, wherein a weight average molecular weight of said polymer (A' 1), prior to protection with said acid dissociable, dissolution inhibiting groups, is within a range from 2,000 to 30,000.

8. A positive resist composition for a low-acceleration electron beam according to claim 4, wherein a proportion of said structural units (a21) within said polymer (A'1) is within a range from 5 to 35 mol%.

9. A positive resist composition for a low-acceleration electron beam according to claim 3, wherein said resin component (A') is a copolymer (A'2) comprising said structural units (a11), and structural units (a12) derived from a (meth)acrylic acid containing an aliphatic polycyclic group with an alcoholic hydroxyl group, and a portion of hydroxyl groups of said structural units (a11) and alcoholic hydroxyl groups of said structural units (a12) are protected with acid dissociable, dissolution inhibiting groups.

10. A positive resist composition for a low-acceleration electron beam according to claim 9, wherein a weight average molecular weight of said copolymer (A'2), prior to protection with said acid dissociable, dissolution inhibiting groups, is at least 2,000 but no more than 8,500.

11. A positive resist composition for a low-acceleration electron beam according to claim 9, wherein from 10 to 35 mol% of a combined total of hydroxyl groups of said structural units (a11) and alcoholic hydroxyl groups of said structural units (a12) within said copolymer (A'2) are protected with said acid dissociable, dissolution inhibiting groups.

12. A positive resist composition for a low-acceleration electron beam according to claim 9, wherein a molar ratio between said structural units (a11) and said structural units (a12) within said copolymer (A'2) prior to protection with said acid dissociable, dissolution inhibiting groups is within a range from 95:5 to 75:25.

13. A positive resist composition for a low-acceleration electron beam according to claim 9, wherein said structural units (a12) are derived from a (meth)acrylate ester containing an adamantyl group with an alcoholic hydroxyl group.

14. A positive resist composition for a low-acceleration electron beam according to claim 9, wherein said structural units (a12) comprise only structural units derived from an acrylate ester containing an aliphatic polycyclic group with an alcoholic hydroxyl group.

15. A positive resist composition for a low-acceleration electron beam according to claim 9, wherein said acid dissociable, dissolution inhibiting groups are 1-lower alkoxyalkyl groups.

16. A positive resist composition for a low-acceleration electron beam according to claim 9, wherein said copolymer (A'2) further comprises structural units (a3) represented by a general formula (III) shown below: 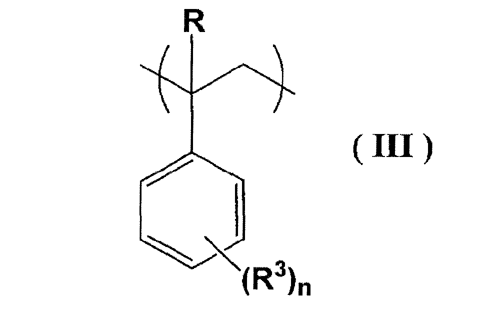 [wherein, R represents a hydrogen atom or a methyl group, R³ represents an alkyl group of 1 to 5 carbon atoms, and n represents either 0 or an integer of 1 to 3].

17. A positive resist composition for a low-acceleration electron beam according to claim 4, wherein a dispersity of said polymer (A'1) prior to protection with said acid dissociable, dissolution inhibiting groups is no higher than 2.0.

18. A positive resist composition for a low-acceleration electron beam according to claim 9, wherein a dispersity of said copolymer (A'2) prior to protection with said acid dissociable, dissolution inhibiting groups is no higher than 2.0.

19. A positive resist composition for a low-acceleration electron beam according to either one of claim 1 and claim 2, further comprising a nitrogen-containing organic compound (D), wherein said component (D) comprises a secondary or tertiary aliphatic amine containing an alkyl group of 7 to 15 carbon atoms.

20. A positive resist composition for a low-acceleration electron beam according to either one of claim 1 and claim 2, which is used for a multi-layer resist laminate.

21. A resist laminate comprising a lower organic film layer that can be dry etched, an interlayer, and an upper resist film layer laminated sequentially on top of a substrate, wherein
said upper resist film layer is formed from a positive resist composition for a low-acceleration electron beam that comprises a resin component (A), which contains acid dissociable, dissolution inhibiting groups and exhibits increased alkali solubility under action of acid, and an acid generator component (B) that generates acid on exposure, and a residual film ratio for said upper resist film layer is 80% or higher.

22. A resist laminate comprising a lower organic film layer that can be dry etched, an interlayer, and an upper resist film layer laminated sequentially on top of a substrate, wherein
said upper resist film layer is formed from a positive resist composition for a low-acceleration electron beam that comprises a resin component (A'), which contains alkali-soluble structural units (a1) and structural units (a2) that contain an acid dissociable, dissolution inhibiting group, and exhibits increased alkali solubility under action of acid, and an acid generator component (B) that generates acid on exposure, and at least one of said structural units (a1) and (a2) within said resin component (A') contains a polycyclic group.

23. A resist laminate according to claim 22, wherein in said positive resist composition for a low-acceleration electron beam, said structural units (a1) within said resin component (A') comprise structural units (a11) represented by a general formula (I) shown below: 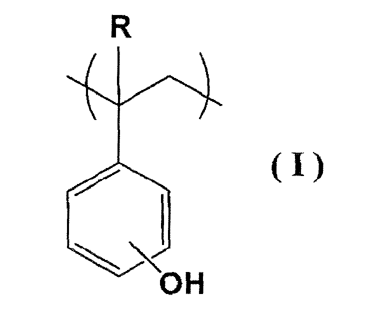 [wherein, R represents a hydrogen atom or a methyl group].

24. A resist laminate according to claim 23, wherein in said positive resist composition for a low-acceleration electron beam, said resin component (A') is a polymer (A'1) containing said structural units (a11), and structural units (a21), in which hydrogen atoms of a portion of hydroxyl groups of said structural units (a11) are protected with acid dissociable, dissolution inhibiting groups represented by a general formula (II) shown below: 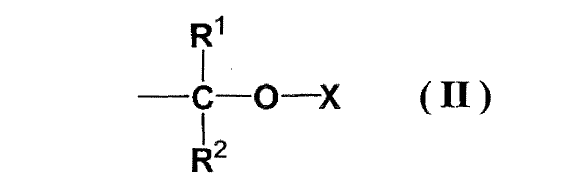 [wherein, R¹ represents an alkyl group of 1 to 5 carbon atoms, R² represents an alkyl group of 1 to 5 carbon atoms or a hydrogen atom, and X represents an aliphatic polycyclic group or an aromatic polycyclic hydrocarbon group].

25. A resist laminate according to claim 24, wherein said polymer (A'1) further comprises structural units (a3) represented by a general formula (III) shown below: 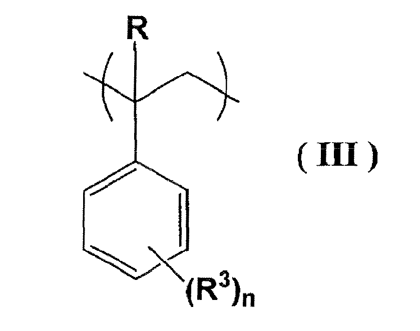 [wherein, R represents a hydrogen atom or a methyl group, R³ represents an alkyl group of 1 to 5 carbon atoms, and n represents either 0 or an integer of 1 to 3].

26. A resist laminate according to claim 24, wherein R within said general formula (I) is a hydrogen atom.

27. A resist laminate according to claim 24, wherein a weight average molecular weight of said polymer (A'1), prior to protection with said acid dissociable, dissolution inhibiting groups, is within a range from 2,000 to 30,000.

28. A resist laminate according to claim 24, wherein a proportion of said structural units (a21) within said polymer (A'1) is within a range from 5 to 35 mol%.

29. A resist laminate according to claim 23, wherein said resin component (A') is a copolymer (A'2) comprising said structural units (a11), and structural units (a12) derived from a (meth)acrylic acid containing an aliphatic polycyclic group with an alcoholic hydroxyl group, and a portion of hydroxyl groups of said structural units (a11) and alcoholic hydroxyl groups of said structural units (a12) are protected with acid dissociable, dissolution inhibiting groups.

30. A resist laminate according to claim 29, wherein a weight average molecular weight of said copolymer (A'2), prior to protection with said acid dissociable, dissolution inhibiting groups, is at least 2,000 but no more than 8,500.

31. A resist laminate according to claim 29, wherein from 10 to 35 mol% of a combined total of hydroxyl groups of said structural units (a11) and alcoholic hydroxyl groups of said structural units (a12) within said copolymer (A'2) are protected with said acid dissociable, dissolution inhibiting groups.

32. A resist laminate according to claim 29, wherein a molar ratio between said structural units (a11) and said structural units (a12) within said copolymer (A'2) prior to protection with said acid dissociable, dissolution inhibiting groups is within a range from 95:5 to 75:25.

33. A resist laminate according to claim 29, wherein said structural units (a12) are derived from a (meth)acrylate ester containing an adamantyl group with an alcoholic hydroxyl group.

34. A resist laminate according to claim 29, wherein said structural units (a12) comprise only structural units derived from an acrylate ester containing an aliphatic polycyclic group with an alcoholic hydroxyl group.

35. A resist laminate according to claim 29, wherein said acid dissociable, dissolution inhibiting groups are 1-lower alkoxyalkyl groups.

36. A resist laminate according to claim 29, wherein said copolymer (A'2) further comprises structural units (a3) represented by a general formula (III) shown below: 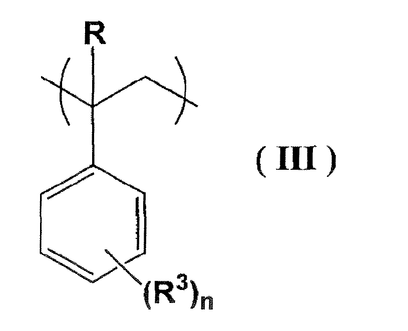 [wherein, R represents a hydrogen atom or a methyl group, R³ represents an alkyl group of 1 to 5 carbon atoms, and n represents either 0 or an integer of 1 to 3].

37. A resist laminate according to claim 24, wherein a dispersity of said polymer (A'1) prior to protection with said acid dissociable, dissolution inhibiting groups is no higher than 2.0.

38. A resist laminate according to claim 29, wherein a dispersity of said copolymer (A'2) prior to protection with said acid dissociable, dissolution inhibiting groups is no higher than 2.0.

39. A resist laminate according to either one of claim 21 and claim 22, wherein said positive resist composition for a low-acceleration electron beam further comprises a nitrogen-containing organic compound (D), and said component (D) comprises a secondary or tertiary aliphatic amine containing an alkyl group of 7 to 15 carbon atoms.

40. A method of pattern formation, comprising sequentially conducting a laminate formation step of forming a resist laminate according to either one of claim 21 and claim 22, a step of conducting exposure of said upper resist film layer of said resist laminate using a low-acceleration electron beam, and then conducting alkali developing to form a resist pattern in said upper resist film layer, a step of conducting oxide etching using said resist pattern as a mask pattern, thereby transferring a pattern to said interlayer, and a step of conducting dry etching of said lower organic film layer using said resist pattern and said pattern within said interlayer as a mask pattern, thereby forming a lower layer pattern within said lower organic film layer.

41. A method of pattern formation according to claim 40, wherein said exposure using said low-acceleration electron beam is conducted through a mask pattern.

42. A method of pattern formation according to claim 41, wherein said oxide etching is conducted using a halogen-based gas.

43. A method of pattern formation according to claim 41, wherein said dry etching is etching that uses an oxygen plasma.
